(19) **Europäisches Patentamt / European Patent Office / Office européen des brevets**

(11) **EP 3 933 305 B1**

(12) **EUROPEAN PATENT SPECIFICATION**

(45) Date of publication and mention
of the grant of the patent:
**08.07.2026 Bulletin 2026/28**

(21) Application number: **20830899.9**

(22) Date of filing: **25.03.2020**

(51) International Patent Classification (IPC):
**F25B 21/02** *(2006.01)* **F25D 23/12** *(2006.01)*
**F25D 11/02** *(2006.01)* **F25D 15/00** *(2006.01)*
**F25B 5/02** *(2006.01)* **F25B 5/04** *(2006.01)*
**H10N 10/13** *(2023.01)* **H10N 10/17** *(2023.01)*
**H10N 19/00** *(2026.01)*

(52) Cooperative Patent Classification (CPC):
**F25D 11/025; F25B 5/02; F25B 5/04; F25B 21/02;
F25B 25/00; F25D 11/022; H10N 10/13;
H10N 10/17; H10N 19/101;** F25B 41/20;
F25B 2600/2507; F25B 2600/2511; F25D 2317/061

(86) International application number:
**PCT/KR2020/004071**

(87) International publication number:
**WO 2020/262803 (30.12.2020 Gazette 2020/53)**

(54) **THERMOELECTRIC MODULE AND REFRIGERATOR COMPRISING SAME**

THERMOELEKTRISCHES MODUL UND KÜHLSCHRANK DAMIT

MODULE THERMOÉLECTRIQUE ET RÉFRIGÉRATEUR LE COMPRENANT

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **26.06.2019 KR 20190076584**

(43) Date of publication of application:
**05.01.2022 Bulletin 2022/01**

(73) Proprietor: **LG Electronics Inc.**
**SEOUL 07336 (KR)**

(72) Inventors:
• **YUN, Seokjun**
**Seoul 08592 (KR)**
• **LIM, Hyoungkeun**
**Seoul 08592 (KR)**

• **LEE, Junghun**
**Seoul 08592 (KR)**
• **LEE, Hoyoun**
**Seoul 08592 (KR)**

(74) Representative: **Vossius & Partner**
**Patentanwälte Rechtsanwälte mbB**
**Siebertstraße 3**
**81675 München (DE)**

(56) References cited:
**JP-A- 2003 078 177      JP-A- 2003 078 177
KR-A- 20120 080 820      KR-A- 20190 014 051
KR-A- 20190 014 051      KR-B1- 101 519 071
KR-B1- 101 519 071      US-A1- 2012 174 955
US-A1- 2018 187 944**

## Description

### TECHNICAL FIELD

The present invention relates to a thermoelectric module and a refrigerator including the same.

### BACKGROUND ART

In general, a refrigerator is a home appliance for storing food at a low temperature, and includes a refrigerating compartment for storing food in a refrigerated state in a range of 3°C and a freezing compartment for storing food in a frozen state in a range of -20°C.

However, when food such as meat or seafood is stored in the frozen state in the existing freezing compartment, moisture in cells of the meat or seafood are escaped out of the cells in the process of freezing the food at the temperature of -20°C, and thus, the cells are destroyed, and taste of the food is changed during an unfreezing process.

However, if a temperature condition of the storage compartment is set to a cryogenic state that is significantly lower than the current temperature of the freezing temperature. Thus, when the food quickly passes through a freezing point temperature range while the food is changed in the frozen state, the destruction of the cells may be minimized, and as a result, even after the unfreezing, the meat quality and the taste of the food may return to close to the state before the freezing. The cryogenic temperature may be understood to mean a temperature in a range of -45°C to -50°C.

For this reason, in recent years, the demand for a refrigerator equipped with a deep freezing compartment that is maintained at a temperature lower than a temperature of the freezing compartment is increasing.

In order to satisfy the demand for the deep freezing compartment, there is a limit to the cooling using an existing refrigerant. Thus, an attempt is made to lower the temperature of the deep freezing compartment to a cryogenic temperature by using a thermoelectric module (TEM).

Korean Patent Publication No. 2018-0105572 (September 28, 2018) that is a prior art discloses a refrigerator having the form of a bedside table, in which a storage compartment has a temperature lower than the room temperature by using a thermoelectric module. Furthermore, KR 10-1519071 B1 discloses a thermoelectric module assembly for a dehumidifier.

However, in the case of the refrigerator using the thermoelectric module disclosed in the prior art, since a heat generation surface of the thermoelectric module is configured to be cooled by heat-exchanged with indoor air, there is a limitation in lowering a temperature of the heat absorption surface.

In detail, in the thermoelectric module, when supply current increases, a temperature difference between the heat absorption surface and the heat generation surface tends to increase to a certain level. However, due to characteristics of the thermoelectric element made of a semiconductor element, when the supply current increases, the semiconductor acts as resistance to increase in self-heat amount. Then, there is a problem that heat absorbed from the heat absorption surface is not transferred to the heat generation surface quickly.

In addition, if the heat generation surface of the thermoelectric element is not sufficiently cooled, a phenomenon in which the heat transferred to the heat generation surface flows back toward the heat absorption surface occurs, and a temperature of the heat absorption surface also rises.

In the case of the thermoelectric module disclosed in the prior art, since the heat generation surface is cooled by the indoor air, there is a limit that the temperature of the heat generation surface is not lower than a room temperature.

In a state in which the temperature of the heat generation surface is substantially fixed, the supply current has to increase to lower the temperature of the heat absorption surface, and then efficiency of the thermoelectric module is deteriorated.

In addition, if the supply current increases, a temperature difference between the heat absorption surface and the heat generation surface increases, resulting in a decrease in the cooling capacity of the thermoelectric module.

### DISCLOSURE OF THE INVENTION

### TECHNICAL PROBLEM

The present invention has been proposed to improve the above-described limitations.

### TECHNICAL SOLUTION

The present invention is given by the independent claims.

A thermoelectric module according to an embodiment of the present invention for achieving the above object include: a cold sink; a thermoelectric element having a heat absorption surface coupled to the cold sink; a heat sink coupled to a heat generation surface of the thermoelectric element to dissipate heat transferred from the cold sink to the outside of the thermoelectric element; and a sealing cover for connecting an edge of the cold sink and the edge of the heat sink to surround the thermoelectric element, wherein the cold sink, the heat sink, and the thermoelectric element are integrally formed by the sealing cover.

In addition, the thermoelectric element may be a cascade type thermoelectric element in which two thermoelectric elements having the same or different specifications are coupled to each other.

In addition, in the cascade type thermoelectric element, a heat dissipation sheet may be applied instead of the conventional ceramic substrate, and a metal block may be interposed at a bonding portion of two thermoelectric elements, so that a thickness of the thermoelectric module is significantly reduced.

In addition, the thermoelectric module or the cascade type thermoelectric module in which the heat sink and the cold sink are integrally disposed may be used to cool the deep freezing compartment to an ultra-low temperature of about -50°C.

## ADVANTAGEOUS EFFECTS

The thermoelectric module having the above-described constitutions and the refrigerator including the same according to the embodiment may have following effects.

First, since the ceramic substrate provided on both the ends of the thermoelectric element is removed, there may be the advantage in that the thickness of the thermoelectric module is reduced.

Second, since the material of the plating layer of the electrode portion of the semiconductor element constituting the thermoelectric element is changed from tin (Sn) to gold (Au), the solder wetting may be improved to improve the soldering stability of the semiconductor element.

Third, as the ceramic substrate is removed, there may be the advantage in that the coating process of the thermal grease for bonding the ceramic substrate to the heat sink or the cold sink may be removed.

Fourth, instead of the relatively thick ceramic substrate, the heat dissipation sheet may be interposed in both the ends of the semiconductor device, and the heat dissipation sheet and the heat sink, and the heat dissipation sheet and the cold sink may be integrally coupled to each other to significantly improve the heat transfer effect.

Fifth, the process of sealing the side surface of the thermoelectric element may be eliminated, and the sealing cover directly connecting the heat sink to the cold sink may be provided to simplify the manufacturing process and reduce the manufacturing cost.

## BRIEF DESCRIPTION OF THE DRAWINGS

Fig. 1 is a view illustrating a refrigerant circulation system of a refrigerator according to an embodiment of the present invention.
Fig. 2 is a perspective view illustrating structures of a freezing compartment and a deep freezing compartment of the refrigerator according to an embodiment of the present invention.
FIG. 3 is a longitudinal cross-sectional view taken along line 3-3 of FIG. 2.
Fig. 4 is a graph illustrating a relationship of cooling capacity with respect to an input voltage and a Fourier effect.
Fig. 5 is a graph illustrating a relationship of efficiency with respect to an input voltage and a Fourier effect.
Fig. 6 is a graph illustrating a relationship of cooling capacity and efficiency according to a voltage.
Fig. 7 is a view illustrating a reference temperature line for controlling a refrigerator according to a change in load inside the refrigerator.
Fig. 8 is a cross-sectional view of a thermoelectric module according to a first example not forming part of the present invention.
Fig. 9 is a cross-sectional view of a thermoelectric module according to first embodiment of the present invention.
Fig. 10 is a cross-sectional view of a thermoelectric module according to a second example not forming part of the present invention.
Fig. 11 is a cross-sectional view of a thermoelectric module according to a third example not forming part of the present invention.
Fig. 12 is a cross-sectional view of a thermoelectric module according to a fourth example not forming part of the present invention.
Fig. 13 is a cross-sectional view of a thermoelectric module according to a second embodiment of the present invention.

## MODE FOR CARRYING OUT THE INVENTION

Hereinafter, a thermoelectric module and a refrigerator including the same according to embodiments will be described in detail with reference to the accompanying drawings.

In the present invention, a storage compartment that is cooled by a first cooling device and controlled to a predetermined temperature may be defined as a first storage compartment.

In addition, a storage compartment that is cooled by a second cooling device and is controlled to a temperature lower than that of the first storage compartment may be defined as a second storage compartment.

In addition, a storage compartment that is cooled by the third cooling device and is controlled to a temperature lower than that of the second storage compartment may be defined as a third storage compartment.

The first cooling device for cooling the first storage compartment may include at least one of a first evaporator or a first thermoelectric module including a thermoelectric element. The first evaporator may include a refrigerating compartment evaporator to be described later.

The second cooling device for cooling the second storage compartment may include at least one of a second evaporator or a second thermoelectric module including a thermoelectric element. The second evaporator may include a freezing compartment evaporator to be described later.

The third cooling device for cooling the third storage compartment may include at least one of a third evaporator or a third thermoelectric module including a thermoelectric element.

In the embodiments in which the thermoelectric module is used as a cooling means in the present specification, it may be applied by replacing the thermoelectric module with an evaporator, for example, as follows.

(1) "Cold sink of thermoelectric module", "heat absorption surface of thermoelectric module" or "heat absorption side of thermoelectric module" may be interpreted as "evaporator or one side of the evaporator".
(2) "Heat absorption side of thermoelectric module" may be interpreted as the same meaning as "cold sink of thermoelectric module" or "heat absorption side of thermoelectric module".
(3) A controller "applies or cuts off a constant voltage to the thermoelectric module" may be interpreted as any one of being controlled to "supply or block a refrigerant to the evaporator", "control a switching valve to be opened or closed", or "control a compressor to be turned on or off".
(4) "Controlling the constant voltage applied to the thermoelectric module to increase or decrease" by the controller may be interpreted as any one of "controlling an amount or flow rate of the refrigerant flowing in the evaporator to increase or decrease", "controlling allowing an opening degree of the switching valve to increase or decrease", or "controlling an output of the compressor to increase or decrease".
(5) "Controlling a reverse voltage applied to the thermoelectric module to increase or decrease" by the controller is interpreted as "controlling a voltage applied to the defrost heater adjacent to the evaporator to increase or decrease".

In the present specification, "storage compartment cooled by the thermoelectric module" is defined as a storage compartment A, and "fan located adjacent to the thermoelectric module so that air inside the storage compartment A is heat-exchanged with the heat absorption surface of the thermoelectric module" may be defined as "storage compartment fan A".

Also, a storage compartment cooled by the cooling device while constituting the refrigerator together with the storage compartment A may be defined as "storage compartment B".

In addition, a "cooling device compartment" may be defined as a space in which the cooling device is disposed, in a structure in which the fan for blowing cool air generated by the cooling device is added, the cooling device compartment may be defined as including a space in which the fan is accommodated, and in a structure in which a passage for guiding the cold air blown by the fan to the storage compartment or a passage through which defrost water is discharged is added may be defined as including the passages.

In the present invention, as an example, the first storage compartment may include a refrigerating compartment that is capable of being controlled to an above zero temperature by the first cooling device.

In addition, the second storage compartment may include a freezing compartment that is capable of being controlled to a temperature below zero by the second cooling device.

In addition, the third storage compartment may include a deep freezing compartment that is capable of being maintained at a cryogenic temperature or an ultrafrezing temperature by the third cooling device.

In the present invention, a case in which all of the third to third storage compartments are controlled to a temperature below zero, a case in which all of the first to third storage compartments are controlled to a above zero temperature, and a case in which the first and second storage compartments are controlled to the above zero temperature, and the third storage compartment is controlled to the temperature below zero are not excluded.

Hereinafter, as an example, the description is limited to the case in which the first storage compartment is the refrigerating compartment, the second storage compartment is the freezing compartment, and the third storage compartment is the deep freezing compartment.

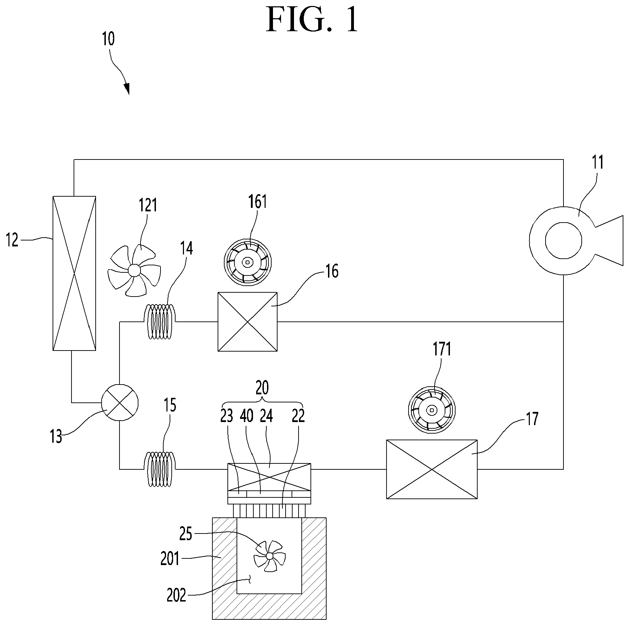

Fig. 1 is a view illustrating a refrigerant circulation system of a refrigerator according to an embodiment of the present invention.

Referring to Fig. 1, a refrigerant circulation system 10 according to an embodiment of the present invention includes a compressor 11 that compresses a refrigerant into a high-temperature and high-pressure gaseous refrigerant, a condenser 12 that condenses the refrigerant discharged from the compressor 11 into a high-temperature and high-pressure liquid refrigerant, an expansion valve that expands the refrigerant discharged from the condenser 12 into a low-temperature and low-pressure two-phase refrigerant, and an evaporator that evaporates the refrigerant passing through the expansion valve into a low-temperature and low-pressure gaseous refrigerant. The refrigerant discharged from the evaporator flows into the compressor 11. The above components are connected to each other by a refrigerant pipe to constitute a closed circuit.

In detail, the expansion valve may include a refrigerator compartment expansion valve 14 and a freezing compartment expansion valve 15. The refrigerant pipe is divided into two branches at an outlet side of the condenser 12, and the refrigerating compartment expansion valve 14 and the freezing compartment expansion valve 15 are respectively connected to the refrigerant pipe that is divided into the two branches. That is, the refrigerating compartment expansion valve 14 and the freezing compartment expansion valve 15 are connected in parallel at the outlet of the condenser 12.

A switching valve 13 is mounted at a point at which the refrigerant pipe is divided into the two branches at the outlet side of the condenser 12. The refrigerant passing through the condenser 12 may flow through only one of the refrigerating compartment expansion valve 14 and the freezing compartment expansion valve 15 by an operation of adjusting an opening degree of the switching valve 13 or may flow to be divided into both sides.

The switching valve 13 may be a three-way valve, and a flow direction of the refrigerant is determined according to an operation mode. Here, one switching valve such as the three-way valve may be mounted at an outlet of the condenser 12 to control the flow direction of the refrigerant, or alternatively, the switching valves are mounted at inlet sides of a refrigerator compartment expansion valve 14 and a freezing compartment expansion valve 15, respectively.

As a first example of an evaporator arrangement manner, the evaporator may include a refrigerating compartment evaporator 16 connected to an outlet side of the refrigerating compartment expansion valve 14 and a heat sink 24 and a freezing compartment evaporator 17, which are connected in series to an outlet side of the freezing compartment expansion valve 15. The heat sink 24 and the freezing compartment evaporator 17 are connected in series, and the refrigerant passing through the freezing compartment expansion valve passes through the heat sink 24 and then flows into the freezing compartment evaporator 17.

Second, as a second example, the heat sink 24 may be disposed at an outlet side of the freezing compartment evaporator 17 so that the refrigerant passing through the freezing compartment evaporator 17 flows into the heat sink 24.

Third, as a third example, a structure in which the deep freezing compartment evaporator 24 and the freezing compartment evaporator 17 are connected in parallel at an outlet end of the freezing compartment expansion valve 15 is not excluded.

Although the heat sink 24 is the evaporator, it is provided for the purpose of cooling a heat generation surface of the thermoelectric module to be described later, not for the purpose of heat-exchange with the cold air of the deep freezing compartment.

In each of the three examples described above with respect to the arrangement manner of the evaporator, a complex system of a first refrigerant circulation system, in which the switching valve 13, the refrigerating compartment expansion valve 14, and the refrigerating compartment evaporator 16 are removed, and a second refrigerant circulation system constituted by the refrigerating compartment cooling evaporator, the refrigerating compartment cooling expansion valve, the refrigerating compartment cooling condenser, and a refrigerating compartment cooling compressor is also possible.

Here, the condenser constituting the first refrigerant circulation system and the condenser constituting the second refrigerant circulation system may be independently provided, and a complex condenser which is provided as a single body and in which the refrigerant is not mixed may be provided.

The refrigerant circulation system of the refrigerator having the two storage compartments including the deep freezing compartment may be configured only with the first refrigerant circulation system.

Hereinafter, as an example, the description will be limited to a structure in which the heat sink and the freezing compartment evaporator 17 are connected in series.

A condensing fan 121 is mounted adjacent to the condenser 12, a refrigerating compartment fan 161 is mounted adjacent to the refrigerating compartment evaporator 16, and a freezing compartment fan 171 is mounted adjacent to the freezing compartment evaporator 17.

A refrigerating compartment maintained at a refrigerating temperature by cold air generated by the refrigerating compartment evaporator 16, a freezing compartment maintained at a freezing temperature by cold air generated by the freezing compartment evaporator 17, and a deep freezing compartment 202 maintained at a cryogenic or ultrafrezing temperature by a thermoelectric module to be described later are formed inside the refrigerator provided with the refrigerant circulation system according to the embodiment of the present invention. The refrigerating compartment and the freezing compartment may be disposed adjacent to each other in a vertical direction or horizontal direction and are partitioned from each other by a partition wall. The deep freezing compartment may be provided at one side of the inside of the freezing compartment, but the present invention includes the deep freezing compartment provided at one side of the outside of the freezing compartment. In order to block the heat exchange between the cold air of the deep freezing compartment and the cold air of the freezing compartment, the deep freezing compartment 202 may be partitioned from the freezing compartment by a deep freezing case 201 having the high thermal insulation performance.

In addition, the thermoelectric module includes a thermoelectric element 40 having one side through which heat is absorbed and the other side through which heat is released when power is supplied, a cold sink 22 mounted on the heat absorption surface of the thermoelectric element 40, a heat sink 24 mounted on the heat generation surface of the thermoelectric element 40, and an insulator 23 that blocks heat exchange between the cold sink 22 and the heat sink 24.

The insulator 23 may not be required according to an example of the thermoelectric element 40 described below.

Here, the heat sink 24 is an evaporator that is in contact with the heat generation surface of the thermoelectric element 40. That is, the heat transferred to the heat generation surface of the thermoelectric element 40 is heat-exchanged with the refrigerant flowing inside the heat sink 24. The refrigerant flowing along the inside of the heat sink 24 and absorbing heat from the heat generation surface of the thermoelectric element 40 is introduced into the freezing compartment evaporator 17.

In addition, a cooling fan may be provided in front of the cold sink 22, and the cooling fan may be defined as the deep freezing compartment fan 25 because the fan is disposed behind the inside of the deep freezing compartment.

The cold sink 22 is disposed behind the inside of the deep freezing compartment 202 and configured to be exposed to the cold air of the deep freezing compartment 202. Thus, when the deep freezing compartment fan 25 is driven to forcibly circulate cold air in the deep freezing compartment 202, the cold sink 22 absorbs heat through heat-exchange with the cold air in the deep freezing compartment and then is transferred to the heat absorption surface of the thermoelectric element 40. The heat transferred to the heat absorption surface is transferred to the heat generation surface of the thermoelectric element 40.

The heat sink 24 functions to absorb the heat absorbed from the heat absorption surface of the thermoelectric element 40 and transferred to the heat generation surface of the thermoelectric element 40 again to release the heat to the outside of the thermoelectric module 20.

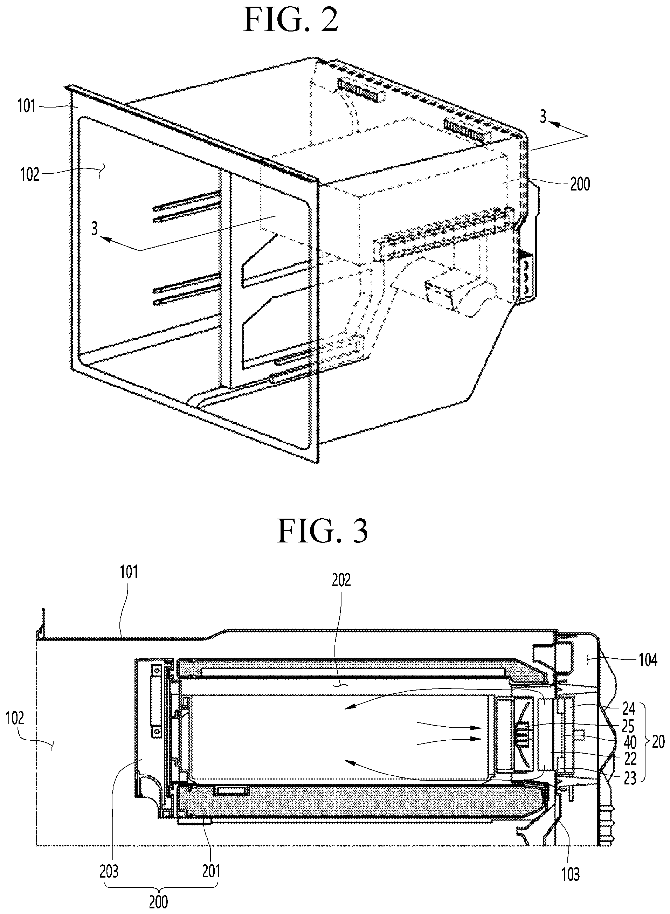

Fig. 2 is a perspective view illustrating structures of the freezing compartment and the deep freezing compartment of the refrigerator according to an embodiment of the present invention, and Fig. 3 is a longitudinal cross-sectional view taken along line 3-3 of Fig. 2.

Referring to FIGS. 2 and 3, the refrigerator according to an embodiment of the present invention includes an inner case 101 defining the freezing compartment 102 and a deep freezing unit 200 mounted at one side of the inside of the freezing compartment 102.

In detail, the inside of the refrigerating compartment is maintained to a temperature of about 3°C, and the inside of the freezing compartment 102 is maintained to a temperature of about -18°C, whereas a temperature inside the deep freezing unit 200, i.e., an internal temperature of the deep freezing compartment 202 has to be maintained to about -50°C. Therefore, in order to maintain the internal temperature of the deep freezing compartment 202 at a cryogenic temperature of -50°C, an additional freezing means such as the thermoelectric module 20 is required in addition to the freezing compartment evaporator.

In more detail, the deep freezing unit 200 includes a deep freezing case 201 that forms a deep freezing compartment 202 therein, a deep freezing compartment drawer 203 slidably inserted into the deep freezing case 201, and a thermoelectric module 20 mounted on a rear surface of the deep freezing case 201.

Instead of applying the deep freezing compartment drawer 203, a structure in which a deep freezing compartment door is connected to one side of the front side of the deep freezing case 201, and the entire inside of the deep freezing compartment 201 is configured as a food storage space is also possible.

In addition, the rear surface of the inner case 101 is stepped backward to form a freezing evaporation compartment 104 in which the freezing compartment evaporator 17 is accommodated. In addition, an inner space of the inner case 101 is divided into the freezing evaporation compartment 104 and the freezing compartment 102 by the partition wall 103. The thermoelectric module 20 is fixedly mounted on a front surface of the partition wall 103, and a portion of the thermoelectric module 20 passes through the deep freezing case 201 and is accommodated in the deep freezing compartment 202.

In detail, the heat sink 24 constituting the thermoelectric module 20 may be an evaporator connected to the freezing compartment expansion valve 15 as described above. A space in which the heat sink 24 is accommodated may be formed in the partition wall 103.

Since the two-phase refrigerant cooled to a temperature of about -18°C to -20°C while passing through the freezing compartment expansion valve 15 flows inside the heat sink 24, a surface temperature of the heat sink 24 may be maintained to a temperature of -18°C to -20°C. Here, it is noted that a temperature and pressure of the refrigerant passing through the freezing compartment expansion valve 15 may vary depending on the freezing compartment temperature condition.

When a rear surface of the thermoelectric element 40 is in contact with a front surface of the heat sink 24, and power is applied to the thermoelectric element 40, the rear surface of the thermoelectric element 40 becomes a heat generation surface.

When the cold sink 22 is in contact with a front surface of the thermoelectric element, and power is applied to the thermoelectric element 40, the front surface of the thermoelectric element 40 becomes a heat absorption surface.

The cold sink 22 may include a heat conduction plate made of an aluminum material and a plurality of heat exchange fins extending from a front surface of the heat conduction plate. Here, the plurality of heat exchange fins extend vertically and are disposed to be spaced apart from each other in a horizontal direction.

Here, when a housing surrounding or accommodating at least a portion of a heat conductor constituted by the heat conduction plate and the heat exchange fin is provided, the cold sink 22 has to be interpreted as a heat transfer member including the housing as well as the heat conductor. This is equally applied to the heat sink 22, and the heat sink 22 has be interpreted not only as the heat conductor constituted by the heat conduction plate and the heat exchange fin, but also as the heat transfer member including the housing when a housing is provided.

The deep freezing compartment fan 25 is disposed in front of the cold sink 22 to forcibly circulate air inside the deep freezing compartment 202.

Hereinafter, efficiency and cooling capacity of the thermoelectric element will be described.

The efficiency of the thermoelectric module 20 may be defined as a coefficient of performance (COP), and an efficiency equation is as follows.

$$COP = \frac{Q_c}{P_e}$$

Qc: Cooling Capacity (ability to absorb heat)
Pe: Input Power (power supplied to thermoelectric element))

$$P_e = V \times i$$

In addition, the cooling capacity of the thermoelectric module 20 may be defined as follows.

$$Q_c = \alpha T_c i - \frac{1}{2} \frac{\rho L}{A} i^2 - \frac{kA}{L} (T_h - T_c)$$

<Semiconductor material property coefficient>

a: Seebeck Coefficient [V/K]
p: Specific Resistance [$\Omega$m-1]
k: Thermal Conductivity [W/mk]

<Semiconductor structure characteristics>

L : Thickness of thermoelectric element : Distance between heat absorption surface and heat generation surface
A : Area of thermoelectric element

<System use condition>

i : Current
V : Voltage
$T_h$ : Temperature of heat generation surface of thermoelectric element
$T_c$ : Temperature of heat absorption surface of thermoelectric element

In the above cooling capacity equation, a first item at the right may be defined as a Peltier Effect and may be defined as an amount of heat transferred between both ends of the heat absorption surface and the heat generation surface by a voltage difference. The Peltier effect increases in proportional to supply current as a function of current.

In the formula V = iR, since a semiconductor constituting the thermoelectric module acts as resistance, and the resistance may be regarded as a constant, it may be said that a voltage and current have a proportional relationship. That is, when the voltage applied to the thermoelectric element 40 increases, the current also increases. Accordingly, the Peltier effect may be seen as a current function or as a voltage function.

The cooling capacity may also be seen as a current function or a voltage function. The Peltier effect acts as a positive effect of increasing in cooling capacity. That is, as the supply voltage increases, the Peltier effect increases to increase in cooling capacity.

The right second item in the cooling capacity equation is defined as a Joule Effect.

The Joule effect means an effect in which heat is generated when current is applied to a resistor. In other words, since heat is generated when power is supplied to the thermoelectric module, this acts as a negative effect of reducing the cooling capacity. Therefore, when the voltage supplied to the thermoelectric module increases, the Joule effect increases, resulting in lowering of the cooling capacity of the thermoelectric module.

The right third item in the cooling capacity equation is defined as a Fourier effect.

The Fourier effect means an effect in which heat is transferred by heat conduction when a temperature difference occurs on both surfaces of the thermoelectric module.

In detail, the thermoelectric module includes a heat absorption surface and a heat generation surface, each of which is provided as a ceramic substrate, and a semiconductor element disposed between the heat absorption surface and the heat generation surface. When a voltage is applied to the thermoelectric module, a temperature difference is generated between the heat absorption surface and the heat generation surface. The heat absorbed through the heat absorption surface passes through the semiconductor and is transferred to the heat generation surface. However, when the temperature difference between the heat absorption surface and the heat absorption surface occurs, a phenomenon in which heat flows backward from the heat generation surface to the heat absorption surface by heat conduction occurs, which is referred to as the Fourier effect.

Like the Joule effect, the Fourier effect acts as a negative effect of lowering the cooling capacity. In other words, when the supply current increases, the temperature difference (Th-Tc) between the heat generation surface and the heat absorption surface of the thermoelectric module, i.e., a value $\Delta T$, increases, resulting in lowering of the cooling capacity.

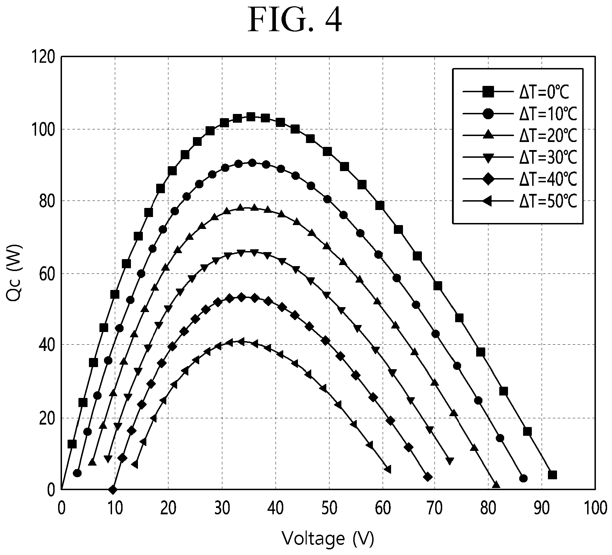

Fig. 4 is a graph illustrating a relationship of cooling capacity with respect to the input voltage and the Fourier effect.

Referring to FIG. 4, the Fourier effect may be defined as a function of the temperature difference between the heat absorption surface and the heat generation surface, that is, a value $\Delta T$.

In detail, when specifications of the thermoelectric module are determined, values k, A, and L in the item of the Fourier effect in the above cooling capacity equation become constant values, and thus, the Fourier effect may be seen as a function with the value $\Delta T$ as a variable.

Therefore, as the value $\Delta T$ increases, the value of the Fourier effect increases, but the Fourier effect acts as a negative effect on the cooling capacity, and thus the cooling capacity decreases.

As shown in the graph of Fig. 4, it is seen that the greater the value $\Delta T$ under the constant voltage condition, the less the cooling capacity.

In addition, when the value $\Delta T$ is fixed, for example, when $\Delta T$ is 30°C, a change in cooling capacity according to a change of the voltage is observed. As the voltage value increases, the cooling capacity increases and has a maximum value at a certain point and then decreases again.

Here, since the voltage and current have a proportional relationship, it should be noted that it is no matter to view the current described in the cooling capacity equation as the voltage and be interpreted in the same manner.

In detail, the cooling capacity increases as the supply voltage (or current) increases, which may be explained by the above cooling capacity equation. First, since the value $\Delta T$ is fixed, the value $\Delta T$ becomes a constant. Since the value $\Delta T$ for each specification of the thermoelectric element is determined, an appropriate specification of the thermoelectric module may be set according to the required value $\Delta T$.

Since the value $\Delta T$ is fixed, the Fourier effect may be seen as a constant, and the cooling capacity may be simplified into a function of the Peltier effect, which is seen as a first-order function of the voltage (or current), and the Joule effect, which is seen as a second-order function of the voltage (or current).

As the voltage value gradually increases, an amount of increase in Peltier effect, which is the first-order function of the voltage, is larger than that of increase in Joule effect, which is the second-order function, of voltage, and consequently, the cooling capacity increases. In other words, until the cooling capacity is maximized, the function of the Joule effect is close to a constant, so that the cooling capacity approaches the first-order function of the voltage.

As the voltage further increases, it is seen that a reversal phenomenon, in which a self-heat generation amount due to the Joule effect is greater than a transfer heat amount due to the Peltier effect, occurs, and as a result, the cooling capacity decreases again. This may be more clearly understood from the functional relationship between the Peltier effect, which is the first-order function of the voltage (or current), and the Joule effect, which is the second-order function of the voltage (or current). That is, when the cooling capacity decreases, the cooling capacity is close to the second-order function of the voltage.

In the graph of Fig. 4, it is confirmed that the cooling capacity is maximum when the supply voltage is in a range of 30 V to about 40 V, more specifically, about 35 V. Therefore, if only the cooling capacity is considered, it is said that it is preferable to generate a voltage difference within a range of 30 V to 40V in the thermoelectric module.

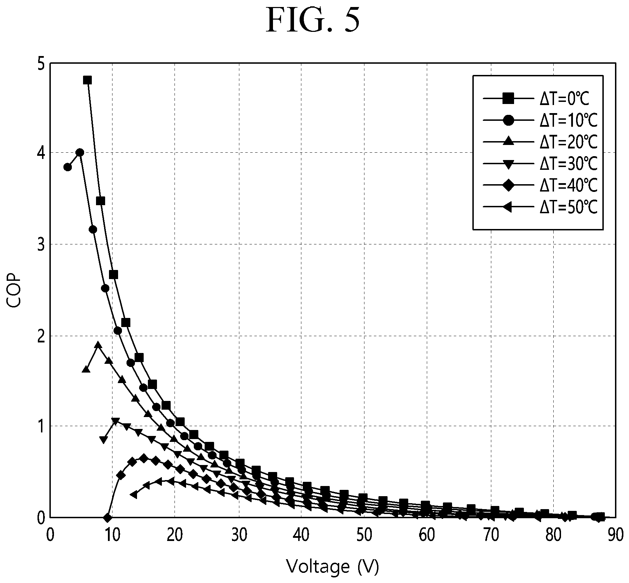

Fig. 5 is a graph illustrating a relationship of efficiency with respect to the input voltage and the Fourier effect.

Referring to Fig. 5, it is seen that the higher the value $\Delta T$, the lower the efficiency at the same voltage. This will be noted as a natural result because the efficiency is proportional to the cooling capacity.

In addition, when the value $\Delta T$ is fixed, for example, when the value $\Delta T$ is limited to 30°C and the change in efficiency according to the change in voltage is observed, the efficiency increases as the supply voltage increases, and the efficiency decreases after a certain time point elapses. This is said to be similar to the graph of the cooling capacity according to the change of the voltage.

Here, the efficiency (COP) is a function of input power as well as cooling capacity, and the input Pe becomes a function of V2 when the resistance of the thermoelectric element 40 is considered as the constant. If the cooling capacity is divided by V2, the efficiency may be expressed as Peltier effect-Peltier effect/V2. Therefore, it is seen that the graph of the efficiency has a shape as illustrated in Fig. 5.

It is seen from the graph of Fig. 5, in which a point at which the efficiency is maximum appears in a region in which the voltage difference (or supply voltage) applied to the thermoelectric module is less than about 20 V. Therefore, when the required value $\Delta T$ is determined, it is good to apply an appropriate voltage according to the value to maximize the efficiency. That is, when a temperature of the heat sink and a set temperature of the deep freezing compartment 202 are determined, the value $\Delta T$ is determined, and accordingly, an optimal difference of the voltage applied to the thermoelectric module may be determined.

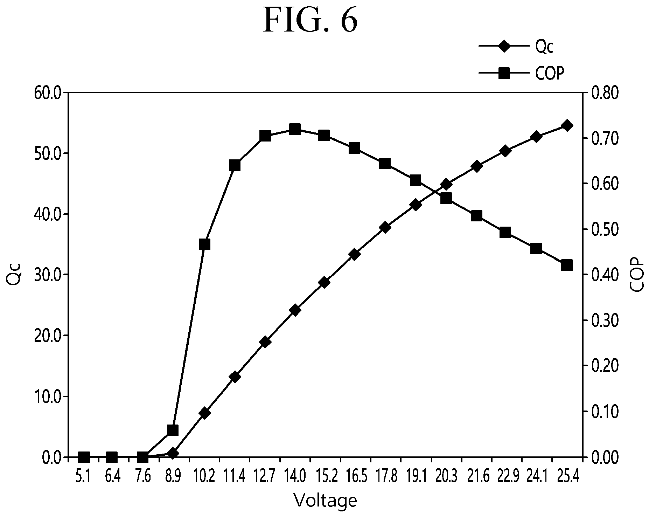

Fig. 6 is a graph illustrating a relationship of the cooling capacity and the efficiency according to a voltage.

Referring to Fig. 6, as described above, as the voltage difference increases, both the cooling capacity and efficiency increase and then decrease.

In detail, it is seen that the voltage value at which the cooling capacity is maximized and the voltage value at which the efficiency is maximized are different from each other. This is seen that the voltage is the first-order function, and the efficiency is the second-order function until the cooling capacity is maximized.

As illustrated in Fig. 6, as an example, in the case of the thermoelectric module having ΔT of 30°C, it is confirmed that the thermoelectric module has the highest efficiency within a range of approximately 12 V to 17 V of the voltage applied to the thermoelectric module. Within the above voltage range, the cooling capacity continues to increase. Therefore, it is seen that a voltage difference of at least 12 V is required in consideration of the cooling capacity, and the efficiency is maximum when the voltage difference is 14 V.

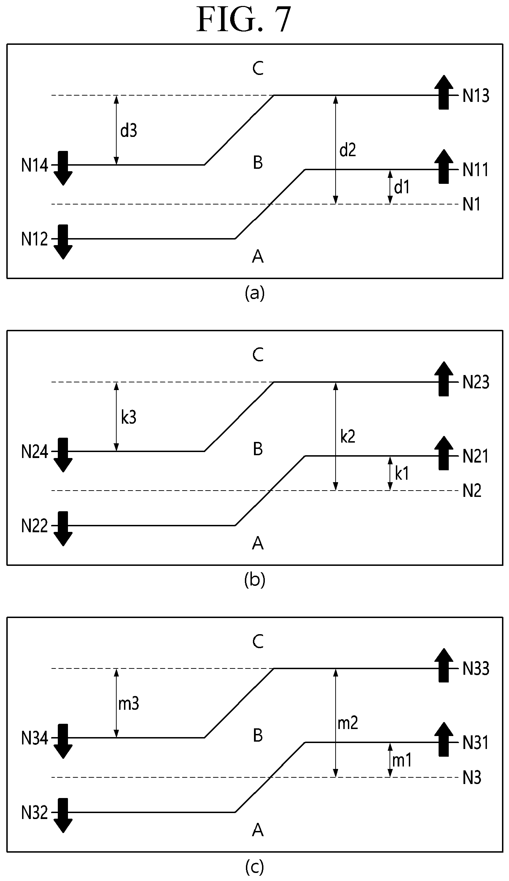

Fig. 7 is a view illustrating a reference temperature line for controlling the refrigerator according to a change in load inside the refrigerator.

Hereinafter, a set temperature of each storage compartment will be described by being defined as a notch temperature. The reference temperature line may be expressed as a critical temperature line.

A lower reference temperature line in the graph is a reference temperature line by which a satisfactory temperature region and a unsatisfactory temperature region are divided. Thus, a region A below the lower reference temperature line may be defined as a satisfactory section or a satisfactory region, and a region B above the lower reference temperature line may be defined as a dissatisfied section or a dissatisfied region.

In addition, an upper reference temperature line is a reference temperature line by which an unsatisfactory temperature region and an upper limit temperature region are divided. Thus, a region C above the upper reference temperature line may be defined as an upper limit region or an upper limit section and may be seen as a special operation region.

When defining the satisfactory/unsatisfactory/upper limit temperature regions for controlling the refrigerator, the lower reference temperature line may be defined as either a case of being included in the satisfactory temperature region or a case of being included in the unsatisfactory temperature region. In addition, the upper reference temperature line may be defined as one of a case of being included in the unsatisfactory temperature region and a case of being included in the upper limit temperature region.

When the internal temperature of the refrigerator is within the satisfactory region A, the compressor is not driven, and when the internal temperature of the refrigerator is in the unsatisfactory region B, the compressor is driven so that the internal temperature of the refrigerator is within the satisfactory region.

In addition, when the internal temperature of the refrigerator is in the upper limit region C, it is considered that food having a high temperature is put into the refrigerator, or the door of the storage compartment is opened to rapidly increase in load within the refrigerator. Thus, a special operation algorithm including a load correspondence operation is performed.

(a) of Fig. 7 is a view illustrating a reference temperature line for controlling the refrigerator according to a change in temperature of the refrigerating compartment.

A notch temperature N1 of the refrigerating compartment is set to a temperature above zero. Also, Fig. 2 is a perspective view of the refrigerator door according to an embodiment In order to allow the temperature of the refrigerating compartment to be maintained to the notch temperature N1, when the temperature of the refrigerating compartment rises to a first satisfactory critical temperature N11 higher than the notch temperature N1 by a first temperature difference d1, the compressor is controlled to be driven, and after the compressor is driven, the compressor is controlled to be stopped when the temperature is lowered to a second satisfactory critical temperature N12 lower than the notch temperature N1 by the first temperature difference d1.

The first temperature difference d1 is a temperature value that increases or decreases from the notch temperature N1 of the refrigerating compartment, and the temperature of the refrigerating compartment may be defined as a control differential or a control differential temperature, which defines a temperature section in which the temperature of the refrigerating compartment is considered as being maintained to the notch temperature N1, i.e., approximately 1.5°C.

In addition, when it is determined that the refrigerating compartment temperature rises from the notch temperature N1 to a first unsatisfactory critical temperature N13 which is higher by the second temperature difference d2, the special operation algorithm is controlled to be executed. The second temperature difference d2 may be 4.5°C. The first unsatisfactory critical temperature may be defined as an upper limit input temperature.

After the special driving algorithm is executed, if the internal temperature of the refrigerator is lowered to a second unsatisfactory temperature N14 lower than the first unsatisfactory critical temperature by a third temperature difference d3, the operation of the special driving algorithm is terminated. The second unsatisfactory temperature N14 may be lower than the first unsatisfactory temperature N13, and the third temperature difference d3 may be 3.0°C. The second unsatisfactory critical temperature N14 may be defined as an upper limit release temperature.

After the special operation algorithm is completed, the cooling capacity of the compressor is adjusted so that the internal temperature of the refrigerator reaches the second satisfactory critical temperature N12, and then the operation of the compressor is stopped.

(b) of Fig. 7 is a view illustrating a reference temperature line for controlling the refrigerator according to a change in temperature of the freezing compartment.

A reference temperature line for controlling the temperature of the freezing compartment have the same temperature as the reference temperature line for controlling the temperature of the refrigerating compartment, but the notch temperature N2 and temperature variations k1, k2, and k3 increasing or decreasing from the notch temperature N2 are only different from the notch temperature N1 and temperature variations d1, d2, and d3.

The freezing compartment notch temperature N2 may be -18°C as described above, but is not limited thereto. The control differential temperature k1 defining a temperature section in which the freezing compartment temperature is considered to be maintained to the notch temperature N2 that is the set temperature may be 2°C.

Thus, when the freezing compartment temperature increases to the first satisfactory critical temperature N21, which increases by the first temperature difference k1 from the notch temperature N2, the compressor is driven, and when the freezing compartment temperature is the unsatisfactory critical temperature (upper limit input temperature) N23, which increases by the second temperature difference k2 than the notch temperature N2, the special operation algorithm is performed.

In addition, when the freezing compartment temperature is lowered to the second satisfactory critical temperature N22 lower than the notch temperature N2 by the first temperature difference k1 after the compressor is driven, the driving of the compressor is stopped.

After the special operation algorithm is performed, if the freezing compartment temperature is lowered to the second unsatisfactory critical temperature (upper limit release temperature) N24 lower by the third temperature difference k3 than the first unsatisfactory temperature N23, the special operation algorithm is terminated. The temperature of the freezing compartment is lowered to the second satisfactory critical temperature N22 through the control of the compressor cooling capacity.

Even in the state that the deep freezing compartment mode is turned off, it is necessary to intermittently control the temperature of the deep freezing compartment with a certain period to prevent the deep freezing compartment temperature from excessively increasing. Thus, the temperature control of the deep freezing compartment in a state in which the deep freezing compartment mode is turned off follows the temperature reference line for controlling the temperature of the freezing compartment disclosed in (b) FIG. 7.

As described above, the reason why the reference temperature line for controlling the temperature of the freezing compartment is applied in the state in which the deep freezing compartment mode is turned off is because the deep freezing compartment is disposed inside the freezing compartment.

That is, even when the deep freezing compartment mode is turned off, and the deep freezing compartment is not used, the internal temperature of the deep freezing compartment has to be maintained at least at the same level as the freezing compartment temperature to prevent the load of the freezing compartment from increasing.

Therefore, in the state that the deep freezing compartment mode is turned off, the deep freezing compartment notch temperature is set equal to the freezing compartment notch temperature N2, and thus the first and second satisfactory critical temperatures and the first and second unsatisfactory critical temperatures are also set equal to the critical temperatures N21, N22, N23, and N24 for controlling the freezing compartment temperature.

(c) of Fig. 7 is a view illustrating a reference temperature line for controlling the refrigerator according to a change in temperature of the deep freezing compartment in a state in which the deep freezing compartment mode is turned on.

In the state in which the deep freezing compartment mode is turned on, that is, in the state in which the deep freezing compartment is on, the deep freezing compartment notch temperature N3 is set to a temperature significantly lower than the freezing compartment notch temperature N2, i.e., is in a range of about -45°C to about -55°C, preferably -55°C. In this case, it is said that the deep freezing compartment notch temperature N3 corresponds to a heat absorption surface temperature of the thermoelectric element 40, and the freezing compartment notch temperature N2 corresponds to a heat generation surface temperature of the thermoelectric element 40.

Since the refrigerant passing through the freezing compartment expansion valve 15 passes through the deep freezing evaporator, i.e., the heat sink 24, the temperature of the heat generation surface of the thermoelectric element 40 that is in contact with the heat sink 24 is maintained to a temperature corresponding to the temperature of the refrigerant passing through at least the freezing compartment expansion valve. Therefore, a temperature difference between the heat absorption surface and the heat generation surface of the thermoelectric module, that is, $\Delta T$ is 32°C.

The control differential temperature m1, that is, the deep freezing compartment control differential temperature that defines a temperature section considered to be maintained to the notch temperature N3, which is the set temperature, is set higher than the freezing compartment control differential temperature k1, for example, 3°C.

Therefore, it is said that the set temperature maintenance consideration section defined as a section between the first satisfactory critical temperature N31 and the second satisfactory critical temperature N32 of the deep freezing compartment is wider than the set temperature maintenance consideration section of the freezing compartment.

In addition, when the deep freezing compartment temperature rises to the first unsatisfactory critical temperature N33, which is higher than the notch temperature N3 by the second temperature difference m2, the special operation algorithm is performed, and after the special operation algorithm is performed, when the deep freezing compartment temperature is lowered to the second unsatisfactory critical temperature N34 lower than the first unsatisfactory critical temperature N33 by the third temperature difference m3, the special operation algorithm is terminated. The second temperature difference m2 may be 5°C.

Here, the second temperature difference m2 of the deep freezing compartment is set higher than the second temperature difference k2 of the freezing compartment. In other words, an interval between the first unsatisfactory critical temperature N33 and the deep freezing compartment notch temperature N3 for controlling the deep freezing compartment temperature is set larger than that between the first unsatisfactory critical temperature N23 and the freezing compartment notch temperature N2 for controlling the freezing compartment temperature.

This is because the internal space of the deep freezing compartment is narrower than that of the freezing compartment, and the thermal insulation performance of the deep freezing case 201 is excellent, and thus, a small amount of the load input into the deep freezing compartment is discharged to the outside. In addition, since the temperature of the deep freezing compartment is significantly lower than the temperature of the freezing compartment, when a heat load such as food is penetrated into the inside of the deep freezing compartment, reaction sensitivity to the heat load is very high.

For this reason, when the second temperature difference m2 of the deep freezing compartment is set to be the same as the second temperature difference k2 of the freezing compartment, frequency of performance of the special operation algorithm such as a load correspondence operation may be excessively high. Therefore, in order to reduce power consumption by lowering the frequency of performance of the special operation algorithm, it is preferable to set the second temperature difference m2 of the deep freezing compartment to be larger than the second temperature difference k2 of the freezing compartment.

<First Example>

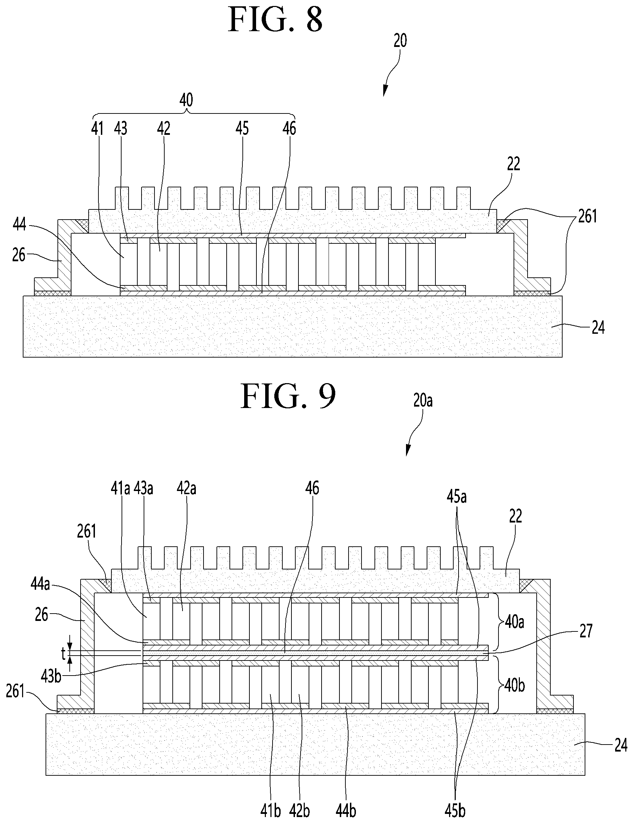

Fig. 8 illustrates a cross-sectional view of a thermoelectric module according to a first example not forming part of the present invention.

Referring to FIG. 8, a thermoelectric module 20 includes a thermoelectric element 40, a cold sink 22 attached to a heat absorption surface of the thermoelectric element 40, a heat sink 24 attached to a heat generation surface of the thermoelectric element 40, and a sealing cover 26 connecting edges of the cold sink 22 and the heat sink 24 to each other.

As described above, the heat sink 24 may be an evaporator through which a low-temperature refrigerant flows, but it should be noted that, like the cold sink 22, a metal member having high thermal conductivity may be used.

In detail, the thermoelectric element 40 may include a semiconductor element portion including a P-type semiconductor element 41 and an N-type semiconductor element 42, a heat absorption-side electrode 43 provided at one end of the semiconductor element portion, and a heat generation-side electrode 44 provided at the other end of the semiconductor element portion.

The heat absorption-side electrode 43 and the heat generation-side electrode 44 may be defined as an electrode portion, and the electrode portion may be a copper (Cu) electrode plated with gold (Au). When compared to an electrode portion of a conventional thermoelectric element made of a copper electrode plated with tin (Sn), the copper electrode portion is plated with gold, and thus, solder wetting has been improved. The solder wetting refers to a degree to which a solder material is evenly distributed on a substrate, and the improved solder wetting means that the solder material is spread evenly and thinly on the substrate.

Thus, as the solder wetting is improved, soldering stability of the semiconductor element portion may be improved.

In addition, the thermoelectric element 40 includes a heat absorption-side heat dissipation sheet 45 interposed between the heat absorption-side electrode 43 and the cold sink 22 and a heat generation-side heat dissipation sheet 46 interposed between the heat absorption-side electrode 43 and the heat sink 24.

The heat absorption-side heat dissipation sheet 45 and the heat generation-side heat dissipation sheet 46 may be defined as a heat dissipation sheet portion, and the heat dissipation sheet portion has a heat transfer function as well as a function of insulating the cold sink 22 or the heat sink 24 from the electrode portion so that electricity does not flow between the cold sink 22 or the heat sink 24 and the electrode portion. That is, it may be understood that the heat dissipation sheet portion replaces a function of a ceramic substrate provided in the conventional thermoelectric element.

In addition, both ends of the sealing cover 26 are connected to edges of the cold sink 22 and the heat sink 24 by an adhesive 261 to prevent foreign substances such as moisture from being introduced into the thermoelectric element 40.

The thermoelectric element 40, the heat sink 24, and the cold sink 22 may be formed as a single body by the sealing cover 26, and as a result, the thermoelectric module may have a thickness that is reduced by a thickness corresponding to that of each of the heat absorption-side and heat generation-side ceramic substrates.

In case of a general thermoelectric element, the heat absorption-side ceramic substrate attached to the heat absorption-side electrode portion forms the heat absorption surface of the thermoelectric element, and the heat generation-side ceramic substrate attached to the heat generation-side electrode portion forms the heat generation surface of the thermoelectric element.

The ceramic substrate allows heat to be transferred between the heat absorption-side and heat generation-side electrode surfaces of the thermoelectric element and between the cold sink and the heat sink and also insulates the heat absorption-side and heat generation-side electrode surfaces of the thermoelectric element from each other and insulates the cold sink and the heat sink from each other so that electricity does not flow therebetween.

The thickness of the ceramic substrate may increase to withstand damage due to external force For example, the thickness of the ceramic substrate may be greater than that of the electrode portion of the thermoelectric element. As the thickness of the ceramic substrate increases, heat transfer from the electrode portion of the thermoelectric element to the cold sink or the heat sink may decrease. Thus, if a heat dissipation sheet having a thinner thickness while performing the heat transfer function and the insulating function is used, efficiency of the thermoelectric element may be improved.

As an example of the heat dissipation sheet according to the present invention, a metal material having strength greater than that of the ceramic may be considered. When a metal having the same material as that of the cold sink or the heat sink is used, thermal resistance generated between metals having different materials may be reduced if the cold sink or the heat sink is designed with an aluminum material, the aluminum material may also be suitable for the heat dissipation sheet. The aluminum material has excellent thermal conductivity higher about 10 times than that of ceramic. In addition, the aluminum material also has an excellent insulating function compared to iron forming a case of the refrigerator.

In the case of the general thermoelectric element, a sealing material is attached and sealed between a side surface portion of the heat absorption-side ceramic substrate and a side surface portion of the heat generation-side ceramic substrate to prevent foreign substances from being introduced into the semiconductor portion of the thermoelectric element.

In such a configuration, another heat conduction path may be formed at a position adjacent to the heat absorption surface and the heat generation surface of the thermoelectric element, and thus, heat transfer may occur through the sealing material to reduce efficiency of the thermoelectric element.

Therefore, it may be advantageous to dispose the sealing material at a place spaced apart from the heat absorption surface and the heat generation surface of the thermoelectric element as necessary. Since the sealing cover 26 according to the present invention is disposed to be spaced apart from the thermoelectric element and is configured to connect and seal the cold sink 22 and the heat sink 24, the efficiency of the thermoelectric element may be improved.

In addition, it is possible to improve work convenience by coupling the sealing cover between the cold sink and the heat sink rather than coupling the sealing material between the heat absorption surface and the heat generation surface of the thermoelectric element.

<First Embodiment>

Fig. 9 is a cross-sectional view of a thermoelectric module according to a first embodiment of the present invention.

Referring to Fig. 9, in a thermoelectric module 20a according to a first embodiment of the present invention, two thermoelectric elements 40a and 40b are disposed between a cold sink 22 and a heat sink 24, and the two thermoelectric elements 40a and 40b has a structure partitioned by a heat transfer block 27.

Also, in the thermoelectric module 20a according to the present embodiment, like the thermoelectric module 20 according to the first example, a sealing cover 26 is surrounded around an edge of the cold sink 22 and an edge of the heat sink 24 to prevent foreign substances from being introduced into the thermoelectric module 20a.

Also, like the thermoelectric module 20 according to the first example, a heat dissipation sheet portion replaces a ceramic substrate.

In detail, the two thermoelectric elements constituting the thermoelectric module 20a according to the first embodiment includes a first thermoelectric element 40a and a second thermoelectric element 40b, and the first and second thermoelectric elements 40a and 40b have the same structure.

Since the first thermoelectric element 40a has a heat absorption surface attached to the cold sink 22 to absorb heat, the first thermoelectric element 40a may be defined as a heat absorption-side thermoelectric element 40a.

The second thermoelectric element 40b has a heat generation surface attached to the heat sink 24 to release the heat transferred through the heat absorption-side thermoelectric element 40a to the heat sink 24, the second thermoelectric element 40b may be defined as a heat generation-side thermoelectric element 40b.

As described above, the thermoelectric module in which two thermoelectric elements are connected to be heat-transferable may be defined as a cascade type thermoelectric element or thermoelectric module. In the cascade type thermoelectric element, the heat generation surface of the first thermoelectric element is connected to be heat-exchangeable with the heat absorption surface of the second thermoelectric element, the cold sink is connected to be heat-transferable to the heat-absorption surface of the first thermoelectric element, and the heat sink is connected to be heat-transferable to the heat generation surface of the second thermoelectric element.

The technical meaning of the mounting of the heat transfer block 27 may be described in various aspects as follows.

The heat transfer block 27 may be disposed between the heat generation surface of the first thermoelectric element 40a and the heat absorption surface of the second thermoelectric element 40b.

In another aspect, one surface of the heat transfer block 27 may be coupled to the heat generation surface of the first thermoelectric element 40a, and the other surface of the heat transfer block 27 may be coupled to the heat absorption surface of the second thermoelectric element 40b.

In order to reduce a backflow of heat between the heat generation surface of the first thermoelectric element 40a and the heat absorption surface of the second thermoelectric element 40b, the heat transfer block 27 may be disposed between the heat generation surface of the first thermoelectric element 40a and the heat absorption surfaces of the second thermoelectric element 40b.

The heat transfer block 27 may function as a type of heat transfer path formed between the heat generation surface of the first thermoelectric element 40a and the heat absorption surface of the second thermoelectric element 40b.

If there is no heat transfer path, the heat transferred from the cold sink 22 does not flow toward the heat sink 24, and the heat may be stagnated between the heat absorption surface of the first thermoelectric element 40a and the heat absorption surface of the second thermoelectric element 40b.

If there is no heat transfer path, the heat transferred from the cold sink 22 may not flow toward the heat sink 24 but flow backward. However, there is a disadvantage in that as a longitudinal cross-sectional area of the heat transfer path, which is capable of being defined by a size of a plane crossing a heat flow direction, i.e., a thickness of the heat transfer block increases, thermal resistance increases. In addition, as a length or width of the heat transfer block increases, the thermal resistance may decrease. Here, the length or width of the heat transfer block may be defined as a length extending in a direction crossing the thickness t of the heat transfer block. For example, the length of the heat transfer block may be defined as a length extending in an x-axis direction, and the width of the heat transfer block may be defined on the same plane as the x-axis to extend in a y-axis direction intersecting the x-axis, and the thickness t of the heat transfer block may be defined as a length extending in a z-axis direction intersecting the x-axis and the y-axis.

The two thermoelectric elements 40a and 40b include semiconductor element portions including P-type semiconductors 41a and 41b and N-type semiconductors 42a and 42b and electrode portions including heat absorption-side electrodes 43a and 43b and heat generation-side electrodes 44a and 44b, respectively.

A thickness of the heat transfer block 27 may be greater than that of the electrode portion of each of the thermoelectric elements 40a and 40b. The thickness of the heat transfer block 27 may be less than that of the semiconductor element portion of the thermoelectric device. The thickness of the heat transfer block may be less than each of that of the semiconductor element portion of the first thermoelectric element 40a and that of the semiconductor element portion of the second thermoelectric element 40b.

The length of the heat transfer block 27 may be greater than that of the electrode portion of each of the thermoelectric elements 40a and 40b. The length of the heat transfer block 27 may be greater than that of the semiconductor element portion of the thermoelectric element.

The heat absorption-side thermoelectric element 40a includes a pair of heat absorption-side heat dissipation sheets 45a, and the heat absorption-side thermoelectric element 40b includes a pair of heat absorption-side heat dissipation sheets 45b.

The pair of heat absorption-side heat dissipation sheets 45a may include a first heat dissipation sheet interposed between the heat absorption-side electrode 43a and the cold sink 22 and a second heat dissipation sheet interposed therebetween the heat generation-side electrode 44a and the heat transfer block 27.

The pair of heat dissipation sheets 45b includes a third heat dissipation sheet interposed between the heat transfer block 27 and the heat absorption-side electrode 43b and a fourth heat dissipation sheet interposed between the heat dissipation electrode 44b and the heat sink 24.

The heat dissipation sheet portion may be understood as an insulating heat transfer sheet that prevents electricity from flowing to the cold sink 22 and the heat sink 24 and allows only the heat transfer.

The heat transfer block 27 includes a non-electric conductive metal block having a large heat transfer coefficient and may include, for example, an aluminum block having the form of a plate.

In addition, the heat dissipation sheets 45a and 45b may respectively adhere to the cold sink 22, the heat sink 24, and the heat transfer block 27 by thermal grease.

According to the present embodiment, at least two thermoelectric elements may be disposed between the cold sink 22 and the heat sink 24 to divide a temperature difference $\Delta T$ between the heat absorption surface of the thermoelectric module 20a, which is heat-exchanged with the cold sink 22, and the heat generation surface of the thermoelectric module 20a, which is heat-exchanged with the heat sink 24, into a first temperature difference $\Delta T1$ and a second temperature difference $\Delta T2$.

In detail, in order to achieve the required temperature difference $\Delta T$ between the heat absorption surface and the heat generation surface by using one thermoelectric element, power consumption for driving the thermoelectric element increases, and cooling capacity $Qc$ of the thermoelectric element decreases, and as a result, this causes a problem that the efficiency of the thermoelectric element is deteriorated.

In order to minimize this problem, two thermoelectric elements 40a and 40b, each of which has a small specification in temperature difference ΔT between the heat absorption surface and the heat generation surface may be disposed between the heat sink and the cold sink to cool the storage compartment (e.g., the deep freezing compartment) cooled by the cold sink 22 to a desired temperature and also reduce the power consumption.

For example, in order to cool the deep freezing compartment to a temperature of -50°C, when a heat sink 24 through which a refrigerant having a temperature of about -20°C flows is employed, and a thermoelectric module constituted by a single thermoelectric element is employed, a thermoelectric element having a specification in which the temperature difference ΔT between the heat absorption surface and heat generation surface is 30°C is required.

In order to cool the deep freezing compartment to a set temperature using the thermoelectric module, a voltage of about 18V has to be applied to the thermoelectric element. In addition, since the temperature difference is large, the cooling capacity and efficiency are inevitably reduced due to the characteristics of the thermoelectric element.

However, when using a cascade type thermoelectric element in which two thermoelectric elements having a specification of less than 30°C are continuously disposed, a temperature difference between the heat sink and the cold sink is maintained at 30°C to improve the cooling capacity and efficiency of the module.

A magnitude of a voltage applied to each of the two thermoelectric elements may not be significantly different from that of a voltage applied to the thermoelectric module including the single thermoelectric element. However, when comparing a time taken to lower the temperature of the heat absorption surface of the thermoelectric module to the set temperature and lower the deep freezing compartment temperature to the set temperature, a time taken when the cascade type thermoelectric module is applied is shorter than that taken when the single thermoelectric element is applied. Thus, it is seen that the cooling capacity of the cascade type thermoelectric module is improved, and the power consumption is reduced, and thus, the efficiency of the thermoelectric module is improved.

The performance of the cascade type thermoelectric module varies according to the magnitude of the voltage applied to each of the two thermoelectric elements.

In detail, the thermoelectric element having the same specification, in which the temperature difference ΔT1 between the heat absorption surface and the heat generation surface of the first thermoelectric element 40a and the temperature difference ΔT2 between the heat absorption surface and the heat generation surface of the second thermoelectric element 40b have the same value, may be provided, or the thermoelectric element having a different specification, in which the temperature differences are different.

When an amount of current supplied to the two thermoelectric elements is the same, and the thermoelectric elements having different temperature differences are applied, the temperature difference ΔT2 of the second thermoelectric element 40b is equal to or less than that ΔT1 of the first thermoelectric element 40a.

In detail, since the smaller the temperature difference ΔT, the greater the cooling capacity of the thermoelectric element, it is advantageous to be disposed the thermoelectric element having the relatively small temperature difference ΔT toward the heat sink 24 when the same current is supplied.

Referring to the equation with respect to the cooling capacity Qc of the thermoelectric element described above, as the temperature difference decreases, the cooling capacity of the thermoelectric element may increase.

In other words, the cooling capacity of the second thermoelectric element 40b is greater than that of the first thermoelectric element 40a, and thus an amount $Q_{out}$ of heat transferred to the heat generation surface of the first thermoelectric element 40a may be completely absorbed from the heat absorption surface of the second thermoelectric element 40b and transferred to the heat sink 24.

When the heat absorption surface of the second thermoelectric element 40b does not completely absorb the heat transferred from the heat generation surface of the first thermoelectric element 40a, the efficiency of the thermoelectric module 20a may decrease.

For reference, an amount $Q_{out}$ of heat released from the heat generation surface of the first thermoelectric element 40a is defined as a sum of the amount Qc of heat absorbed through the cold sink 22 and an amount Pe of power supplied to the first thermoelectric element 40a and is expressed as J (Joule) or Kcal.

On the other hand, when the temperature difference specifications of the first thermoelectric element 40a and the second thermoelectric element 40b are set to

$$\Delta T1 = \Delta T2 = \frac{\Delta T}{2}$$

be the same ( ), amounts of current (or voltage difference) applied to the first thermoelectric element 40a and the second thermoelectric element 40b may be differently controlled to maximally improve the efficiency of the thermoelectric module 20a.

First, a case in which a voltage having the same magnitude is applied to the first thermoelectric element 40a and the second thermoelectric element 40b will be described. The voltage having the same magnitude may be any one of the same high voltage, the same medium voltage, and the same low voltage.

When a predetermined voltage Va is supplied to the first thermoelectric element 40a, an amount $Q^{out1}$ of heat released to the heat generation surface of the first thermoelectric element 40a is as follows

$$Q_{out1} = Q_{c1} + P_{e1}$$

When a predetermined voltage Va is supplied to the first thermoelectric element 40a and the second thermoelectric element 40b, an amount $Q_{out2}$ of heat that has to be released through the heat sink 24 attached to the heat generation surface of the second thermoelectric element 40b is as follows.

$$Q_{out2} = Q_{out1} + P_{e2},$$

$P_{e2}$: Amount of power supplied to the second thermoelectric element 40b
Here, when the heat sink 24 is an evaporator through which the refrigerant passing through the freezing compartment expansion valve flows, a surface temperature of the heat sink 24 is maintained at a temperature in a range of approximately -25°C to -30°C.

In this case, in order that the heat sink 24 quickly absorbs the heat amount $Q_{out2}$, the temperature of the refrigerant passing through the heat sink 24 has to be lowered, or the heat sink 24 has to be designed to be very large. That is, when a voltage having the same magnitude is applied to the two thermoelectric elements, heat absorbed from the cold sink 22 is not rapidly released through the heat sink 24.

In another aspect, when the heat sink 24 is designed to be very large, there may be a disadvantage in that a volume of the storage compartment of the refrigerator is relatively reduced.

In addition, in order to further lower the temperature of the refrigerant passing through the heat sink 24, it may be difficult to develop a new refrigerant having efficiency greater than the current refrigerant.

In addition, in order to further lower the temperature of the refrigerant passing through the heat sink 24, there may be a disadvantage in that the components of the refrigerant circulation system such as the compressor and the condenser of the refrigerator have to be designed to be larger. Due to this, the volume of the storage compartment of the refrigerator may be further reduced.

Thus, while the power consumption increases, the cooling capacity of the thermoelectric module 20a decreases to deteriorate the efficiency of the thermoelectric module 20a.

In this problem, when the voltage applied to the first thermoelectric element 40a is greater than the voltage applied to the second thermoelectric element 40b, since the heat released from the heat generation surface of the second thermoelectric module 40b through the heat generation surface of the first thermoelectric element 40a may not be completely absorbed to further deteriorate the efficiency of the thermoelectric module 20a.

On the other hand, when the voltage applied to the second thermoelectric element 40b is greater than the voltage applied to the first thermoelectric element 40a, the heat absorbed through the heat absorption surface of the first thermoelectric element 40a may be completely absorbed by the second thermoelectric element and then be released to the outside of the thermoelectric module 20a through the heat sink 24.

Particularly, when the high voltage is applied to the second thermoelectric element 40b, any one of the medium voltage and the low voltage may be applied to the first thermoelectric element 40a, and when the medium voltage is applied to the second thermoelectric element 40b, the low voltage may be applied to the first thermoelectric element 40a in terms of improving the efficiency of the thermoelectric module 20a.

It should be noted that the power control or voltage control of the cascade type thermoelectric module including the two thermoelectric elements described above is equally applied to the cascade type thermoelectric module according to the second and third examples described below.

The thermoelectric module according to the present invention includes a cold sink 22, a first thermoelectric element 40a having a heat absorption surface connected to the cold sink, a second thermoelectric element having a heat absorption surface connected to a heat generation surface of the first thermoelectric element 40a, and a heat sink 24 connected to a heat generation surface of the second thermoelectric element 40b to release heat transferred from the cold sink 22 to the outside.

The first thermoelectric element 40a includes a semiconductor element portion including a P-type semiconductor and an N-type semiconductor, a heat absorption-side electrode portion 43a formed at one end of the semiconductor element portion and connected to the cold sink, and a heat generation-side electrode portion 44a formed at the other end of the semiconductor element portion and connected to the heat absorption surface of the second thermoelectric element.

The second thermoelectric element 40b includes a semiconductor element portion including a P-type semiconductor and an N-type semiconductor, a heat absorption-side electrode portion 43b formed at one end of the semiconductor element portion and connected to the heat generation surface of the first thermoelectric element 40a, and a heat generation-side electrode portion 44b formed at the other end of the semiconductor element portion and connected to the heat sink.

The thermoelectric module further includes a sealing cover connecting an edge of the cold sink to an edge of the heat sink.

Such a configuration may improve work convenience.

The sealing cover is configured to seal the edge of the cold sink and the edge of the heat sink. This configuration may prevent foreign substances from being introduced into the thermoelectric element.

The sealing cover may be disposed to be spaced apart from the first and second thermoelectric elements 40a and 40b. This configuration may improve the heat transfer efficiency of the thermoelectric module.

The thermoelectric module further includes a first heat dissipation sheet 45a connected between the cold sink 22 and the heat absorption-side electrode portion of the first thermoelectric element 40a and a second heat dissipation sheet 45b connected between the heat sink 24 and the heat generation-side electrode portion of the second thermoelectric element 40b.

The first and second heat dissipation sheets 45a, 45b may perform a heat transfer function and an insulating function.

The thermoelectric module may further include a heat transfer block 27 interposed between the first thermoelectric element 40a and the second thermoelectric element 40b.

The heat absorption-side electrode portion of the first thermoelectric element 40a may be attached to the cold sink, and the heat generation-side electrode portion of the second thermoelectric element 40b may be attached to the heat sink 24.

The heat generation-side electrode portion of the first thermoelectric element 40a may be attached to one surface of the heat transfer block 27, and the heat absorption-side electrode portion of the second thermoelectric element 40b may be attached to the other surface of the heat transfer block 27.

The heat transfer block 27 may reduce heat transferred from the cold sink 22 from flowing backward instead of flowing toward the heat sink 24.

The controller may control a voltage so that either the high voltage or the low voltage lower than the high voltage is applied to the first thermoelectric element 40a and the second thermoelectric element 40b.

The controller may control a voltage applied to the second thermoelectric element 40b to be greater than a voltage applied to the first thermoelectric element 40a. This configuration may reduce the increase in size of the heat sink 24 as well as reduce the increase in means for cooling the heat sink 24.

Thus, it is possible to reduce an increase in volume of the evaporation compartment of the refrigerator, and as a result, it is possible to increase in volume of the storage compartment of the refrigerator.

The temperature difference $\Delta T1$ between the heat absorption surface and the heat generation surface of the first thermoelectric element may be equal to or greater than the temperature difference $\Delta T2$ between the heat absorption surface and the heat generation surface of the second thermoelectric element. This is because it is advantageous to design the thermoelectric element adjacent to the heat sink to have large cooling capacity.

<Second Example>

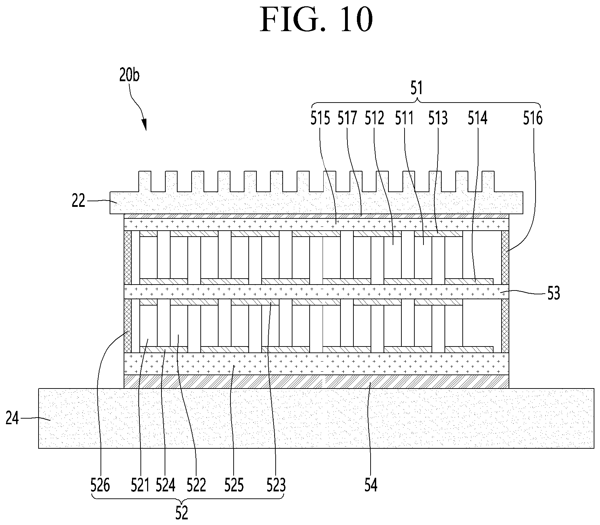

Fig. 10 is a cross-sectional view of a thermoelectric module according to a second example not forming part of the present invention.

Referring to Fig. 10, in a thermoelectric module 20b according to a second example of the present invention, as in the first embodiment, the ideas in which two thermoelectric modules 51 and 52 is disposed between a cold sink 22 and a heat sink 24 is the same. However, there is a slight difference in configuration of the two thermoelectric modules 51 and 52.

In detail, the thermoelectric module 20b according to the second example may include a cold sink 22, a first thermoelectric element 51 having a heat absorption surface attached to the cold sink 22, a second thermoelectric element 52 having a heat absorption surface that is thermally conductively connected to a heat generation surface of the first thermoelectric element 51, a heat sink 24 attached to a heat generation surface of the second thermoelectric element 52, and an intermediate substrate 53 interposed between the first thermoelectric element 51 and a bonding portion of the second thermoelectric element 52.

In more detail, the first thermoelectric element 51 may include a semiconductor element portion, an electrode portion, a heat absorption-side substrate 515, and a sealing member 516.

The semiconductor element portion includes a P-type semiconductor element 511 and an N-type semiconductor element 512.

The electrode unit includes a heat absorption-side electrode 513 provided at one end of the semiconductor element portion and a heat generation-side electrode 514 provided at the other end of the semiconductor element portion.

One surface of the heat absorption-side substrate 515 is attached to the cold sink 22 by thermal grease 517, and the heat absorption-side electrode 513 is formed on the other surface of the heat absorption-side substrate 515.

In addition, the sealing member 516 is surrounded round edges of the heat absorption-side substrate 515 and the intermediate substrate 53.

The second thermoelectric element 52 includes a semiconductor element portion, an electrode portion, a heat generation-side substrate 525, and a sealing member 526.

The semiconductor element portion includes a P-type semiconductor element 521 and an N-type semiconductor element 522.

The electrode unit includes a heat absorption-side electrode 523 provided at one end of the semiconductor element portion and a heat generation-side electrode 524 provided at the other end of the semiconductor element portion.

One surface of the heat generation-side substrate 525 is attached to the heat sink 24 by the thermal grease 54, and the heat generation-side electrode 523 is formed on the other surface of the heat generation-side substrate 525.

In addition, the sealing member 526 is surrounded around the edges of the heat generation-side substrate 525 and the intermediate substrate 53.

A heat generation-side electrode 514 of the first thermoelectric element 51 is formed on one surface of the intermediate substrate 53, and a heat absorption-side electrode 523 of the second thermoelectric element 52 is formed on the other surface of the intermediate substrate 53.

The heat absorption-side substrate 515, the heat generation-side substrate 525, and the intermediate substrate 53 may be made of a ceramic material, like the conventional thermoelectric device. In addition, the sealing members 516 and 526 may also be sealing members of the conventional thermoelectric element for preventing the foreign substances from being introduced into the thermoelectric element by connecting the edges of the ceramic substrate.

According to this example, although the conventional structure in which the two thermoelectric elements are connected to each other, it is characterized in that the single intermediate substrate 53 is coupled to the bonding portion of the two thermoelectric elements.

<Third Example>

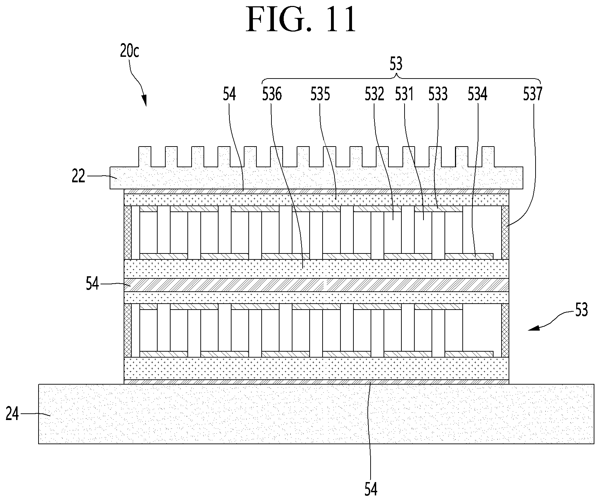

Fig. 11 is a cross-sectional view of a thermoelectric module according to a third example not forming part of the present invention.

Referring to Fig. 11, a thermoelectric module 20c according to a third example has the same structure as the thermoelectric module 20b according to the second example, except that two intermediate substrates are applied.

In detail, in the thermoelectric module 20c according to the third example, a first thermoelectric element 53 and a second thermoelectric element 53 are attached to each other by thermal grease 54 and then attached to a cold sink 22 and a heat sink 24.

The first thermoelectric element 53 and the second thermoelectric element 54 have the same structure as the conventional thermoelectric element structure.

The first thermoelectric element 53 includes a heat absorption-side substrate 535, a heat generation-side substrate 536, a semiconductor element portion, an electrode portion, and a sealing member 537. The semiconductor element portion includes a P-type semiconductor element 531 and an N-type semiconductor element 532.

The electrode portion includes a heat absorption-side electrode 533 formed between one end of the semiconductor element portion and the heat absorption-side substrate 535 and a heat generation-side electrode 534 formed between the other end of the semiconductor electrode portion and the heat generation-side substrate 536. Since the second thermoelectric element 53 has the same structure as the first thermoelectric element 53, a duplicated description thereof will be omitted.

In addition, the heat generation-side substrate 536 of the first thermoelectric element 53 is attached to the heat absorption-side substrate of the second thermoelectric element 54 by the thermal grease 54.

The heat absorption-side substrate 535 of the first thermoelectric element is coupled to the cold sink 22 by the thermal grease 54.

The heat generation-side substrate of the second thermoelectric element is coupled to the heat sink 24 by the thermal grease 54.

In addition, edges of the heat absorption-side substrate 535 and the heat generation-side substrate 536 constituting the first thermoelectric element 53 are connected to each other by the sealing member 537 so that a space in which the semiconductor element portion is accommodated is separated from the outside. This may be also applied to the second thermoelectric element 54.

<Fourth Example>

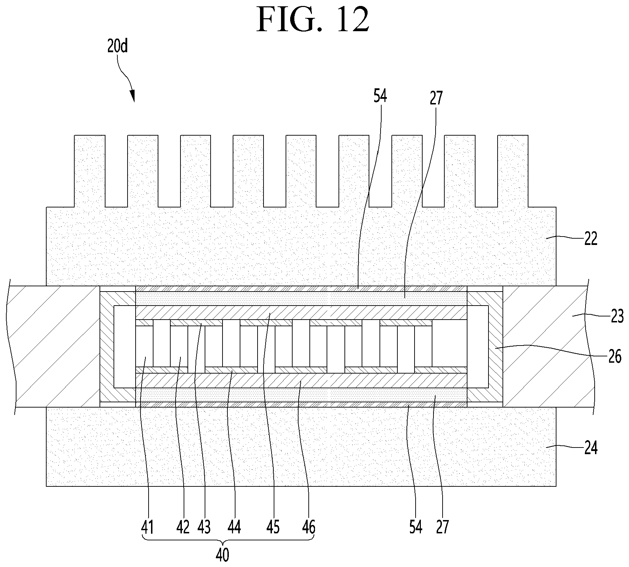

Fig. 12 is a cross-sectional view of a thermoelectric module according to a fourth example not forming part of the present invention.

Referring to Fig. 12, a thermoelectric module 20d according to a fourth example is substantially the same as the structure of the thermoelectric module 20 according to the first example illustrated in FIG. 8, except for the following portions.

First, a heat transfer block 27 is interposed between a heat absorption-side heat dissipation sheet 45 and a cold sink 22 and between a heat generation-side heat dissipation sheet 46 and a heat sink 24, respectively. Also, heat transfer blocks 27 are respectively fixed to a cold sink 22 and a heat sink 24 by thermal grease 54.

Second, both ends of the sealing cover 26 are respectively connected to side surfaces of the two heat transfer blocks 27 to block foreign substances from being introduced into the thermoelectric element.

Here, a heat insulator 23 is interposed between the cold sink 22 and the heat sink 24 to block heat transfer from the heat sink 24 to the cold sink 22.

Since the thermoelectric element 40 according to the present example has the same configuration as that of the thermoelectric element 40 according to the first example, a duplicated description thereof will be omitted.

<Second Embodiment>

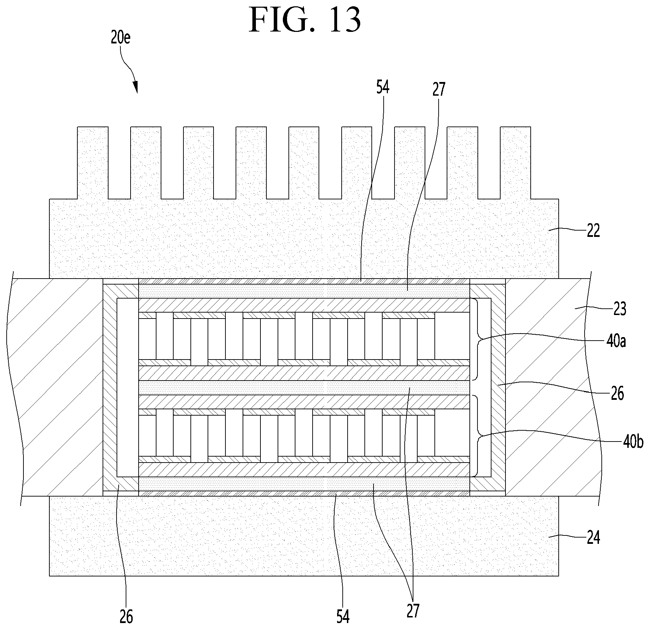

Fig. 13 is a cross-sectional view of a thermoelectric module according to a second embodiment of the present invention.

Referring to Fig. 13, a thermoelectric module 20e according to a second embodiment of the present invention has the same configuration as that of the thermoelectric module 20a according to the first embodiment shown in Fig. 9, except for the following differences.

First, a heat transfer block 27 is interposed between a cold sink 22 and a first thermoelectric element 40a and between a heat sink 24 and a second thermoelectric element 40b, respectively. The heat transfer blocks 27 may be fixed to the cold sink 22 and the heat sink 24 by thermal grease 54, respectively.

Thus, the thermoelectric module 20e according to the second embodiment is different from the thermoelectric module 20a according to the first embodiment in that all three heat transfer blocks 27 are provided.

Here, the heat transfer block attached to the cold sink may be defined as a first heat transfer block, the heat transfer block attached to the heat sink may be defined as a second heat transfer block, and the heat transfer block interposed between the first thermoelectric element 40a and the second thermoelectric element 40b may be defined as a third heat transfer block.

Second, both ends of a sealing cover 26 are coupled to side surfaces of the first heat transfer block and the second heat transfer block. This is substantially the same as the structure of the sealing cover 26 described in the fourth example.

In the second embodiment, like the fourth example, a heat insulator 23 may be interposed between the cold sink 22 and the heat sink 24 to prevent backflow of heat from the heat sink 24 to the cold sink 22.

In summary, the cascade type thermoelectric modules disclosed in the first and embodiments have the following common characteristics.

First, the thermoelectric module includes a first thermoelectric element and a second thermoelectric element.

Second, a heat absorption surface of the first thermoelectric element is thermally conductively connected to the cold sink, and a heat generation surface of the second thermoelectric element is thermally conductively connected to the heat sink.

Third, a heat generation surface of the first thermoelectric element is thermally conductively connected to a heat absorption surface of the second thermoelectric element.

Fourth, magnitudes of a voltage applied to the first thermoelectric element and a voltage applied to the second thermoelectric element may be different. Specifically, the voltage applied to the second thermoelectric element may be greater than the voltage applied to the first thermoelectric element.

Fifth, a space between ceramic substrates is shielded or sealed from an external space by a sealing member, or a space between the cold sink and the heat sink is shielded or sealed from the external space by a sealing cover.

In addition, the thermoelectric modules according to the first and second embodiments have the following common characteristics.

That is, both ends of the semiconductor element portion are soldered to a heat dissipation sheet or a substrate made of a ceramic material by an electrode portion made of copper material, and a plating layer made of a gold (Au) material is formed on the electrode portion to improve solder wetting, thereby improving soldering stability of the semiconductor element portion.

**Claims**

1. A thermoelectric module (20, 20a, 20b, 20c, 20e) comprising:

   a cold sink (22);
   a thermoelectric element (40) of which a heat absorption surface is coupled to the cold sink (22);
   a heat sink (24) coupled to a heat generation surface of the thermoelectric element (40) to release heat transferred from the cold sink (22) to an outside of the thermoelectric element (40); and
   a sealing cover (26) configured to connect an edge of the cold sink (22) and an edge of the heat sink (24), to surround the thermoelectric element (40);
   wherein the thermoelectric element (40) comprises:

      a semiconductor element portion comprising a P-type semiconductor (41) and an N-type semiconductor (42);
      a heat absorption-side electrode portion (43) disposed on one end of the semiconductor element portion; and
      a heat generation-side electrode portion (44) disposed on the other end of the semi-conductor element portion; the thermoelec-tric module further comprising a heat dissipation sheet (45, 46) coupled to an end of the semiconductor element portion,
      wherein an electrode portion of the semiconductor element portion is soldered on the heat dissipation sheet (45, 46), wherein the thermoelectric element (40) comprises:

         a first thermoelectric element (40a) of which a heat absorption surface is coupled to a side of the cold sink (22); and
         a second thermoelectric element (40b) of which a heat generation surface is coupled to a side of the heat sink (24), wherein a heat generation surface of the first thermoelectric element (40a) and a heat absorption surface of the second thermoelectric element (40b) are connected to each other to transfer heat therebetween,
         wherein the heat dissipation sheet (45, 46) comprises:

a first heat dissipation sheet connected between the cold sink (22) and the heat absorption-side electrode portion (43a) of the first thermoelectric element (40a); and
a second heat dissipation sheet connected between the heat sink (24) and the heat generation-side electrode portion (44b) of the second thermoelectric element (40b).

2. The thermoelectric module according to claim 1, further comprising a heat transfer block (27) interposed between bonding portions of the first thermoelectric element (40a) and the second thermoelectric element (40b),

   wherein a heat absorption-side electrode of the first thermoelectric element (40a) is attached to the cold sink (22),
   a heat generation-side electrode of the second thermoelectric element (40b) is attached to the heat sink (24),
   a heat generation-side electrode of the first thermoelectric element (40a) is attached to one surface of the heat transfer block (27), and
   a heat absorption-side electrode of the second thermoelectric element (40b) is attached to the other surface of the heat transfer block (27).

3. The thermoelectric module according to claim 2, further comprising heat transfer blocks (27) interposed respectively, between the cold sink (22) and the bonding portion of the first thermoelectric element (40a) and between the heat sink (24) and the bonding portion of the second thermoelectric element (40b).

4. The thermoelectric module according to claim 1, wherein any one voltage of a high voltage, a medium voltage lower than the high voltage, and a low voltage lower than the medium voltage is applied to the first thermoelectric element (40a) and the second thermoelectric element (40b), and

   an intensity of the voltage applied to the first thermoelectric element (40a) and an intensity of the voltage applied to the second thermoelectric element (40b) are different from each other;
   and preferably
   wherein the voltage applied to the second thermoelectric 'element (40b) is greater than that applied to the first thermoelectric element (40a);
   and preferably
   wherein, when the voltage applied to the second thermoelectric element (40b) is the high voltage, the voltage applied to the first thermoelectric element (40a) is the medium voltage or the low voltage;
or
wherein, when the voltage applied to the second thermoelectric element (40b) is the medium voltage, the voltage applied to the first thermoelectric element (40a) is the low voltage.

5. The thermoelectric module according to claim 1, wherein a temperature difference ($\Delta$T1) between the heat absorption surface and the heat generation surface of the first thermoelectric element (40a) is set to be the same as a temperature difference ($\Delta$T2) between the heat absorption surface and the heat generation surface of the second thermoelectric element (40b);
or
wherein a temperature difference ($\Delta$T1) between the heat absorption surface and the heat generation surface of the first thermoelectric element (40a) is set to be greater than a temperature difference ($\Delta$T2) between the heat absorption surface and the heat generation surface of the second thermoelectric element (40b).

6. The thermoelectric module according to claim 1, wherein the cold sink comprises a heat conductor provided with a plurality of heat exchange pins, and the heat sink comprises a heat conductor provided with a plurality of heat exchange pins or an evaporator through which a low-temperature refrigerant flows.

7. A refrigerator comprising:

   a cabinet having a storage compartment that is maintained to a set temperature lower than room temperature;
   a door configured to open and close the storage compartment; and
   a thermoelectric module provided to cool the temperature of the storage compartment to the set temperature according to any one of claims 1 to 6,
   wherein the cold sink (22) constituting the thermoelectric module is exposed to the storage compartment, and
   the heat sink (24) constituting the thermoelectric module is disposed outside the storage compartment.

8. The refrigerator according to claim 7, wherein the storage compartment comprises any one of a refrigerating compartment maintained to a temperature above a freezing temperature, a freezing compartment maintained to a temperature below the freezing temperature, and a deep freezing compartment maintained to a temperature lower than the freezing temperature.

**9.** The refrigerator according to claim 7, wherein the deep freezing compartment is disposed inside the freezing compartment, and

> the cold sink (22) of the thermoelectric module is exposed to the deep freezing compartment; and preferably the refrigerator further comprising:

>> a refrigerating compartment evaporator (16) provided to cool the refrigerating compartment;
>> a freezing compartment evaporator (17) connected in parallel to the refrigerating compartment evaporator (16) and provided to cool the freezing compartment, wherein the heat sink (24) comprises an evaporator in which a refrigerator flows, and the heat sink (24) is connected in series to an inlet or outlet of the freezing compartment evaporator (17).

**Patentansprüche**

**1.** Thermoelektrisches Modul (20, 20a, 20b, 20c, 20e), das aufweist:

> eine Kältesenke (22);
> ein thermoelektrisches Element (40), vom dem eine Wärmeabsorptionsfläche mit der Kältesenke (22) gekoppelt ist;
> eine Wärmesenke (24), die mit einer Wärmeerzeugungsfläche des thermoelektrischen Elements (40) gekoppelt ist, um von der Kältesenke (22) übertragene Wärme zu einer Außenseite des thermoelektrischen Elements (40) freizusetzen; und
> eine Dichtungsabdeckung (26), die so konfiguriert ist, dass sie eine Kante der Kältesenke (22) und eine Kante der Wärmesenke (24) verbindet, so dass sie das thermoelektrische Element (40) umschließt;
> wobei das thermoelektrische Element (40) aufweist:

>> ein Halbleiterelementabschnitt, der einen p-leitenden Halbleiter (41) und einen n-leitenden Halbleiter (42) aufweist;
>> einen wärmeabsorptionsseitigen Elektrodenabschnitt (43), der an einem Ende des Halbleiterelementabschnitts angeordnet ist; und
>> einen wärmeerzeugungsseitigen Elektrodenabschnitt (44), der an dem anderen Ende des Halbleiterelementabschnitts angeordnet ist;
>> wobei das thermoelektrische Modul ferner eine Wärmeableitungsplatte (45, 46) aufweist, die mit einem Ende des Halbleiterelementabschnitts gekoppelt ist,
wobei ein Elektrodenabschnitt des Halbleiterelementabschnitts auf die Wärmeableitungsplatte (45, 46) gelötet ist, wobei das thermoelektrische Element (40) aufweist:

> ein erstes thermoelektrisches Element (40a), von dem eine Wärmeabsorptionsfläche mit einer Seite der Kältesenke (22) gekoppelt ist; und
> ein zweites thermoelektrisches Element (40b), von dem eine Wärmeerzeugungsfläche mit einer Seite der Wärmesenke (24) gekoppelt ist,
> wobei eine Wärmeerzeugungsfläche des ersten thermoelektrischen Elements (40a) und eine Wärmeabsorptionsfläche des zweiten thermoelektrischen Elements (40b) miteinander verbunden sind, um Wärme zwischen ihnen zu übertragen,
> wobei die Wärmeableitungsplatte (45, 46) aufweist:

>> eine erste Wärmeableitungsplatte, die zwischen der Kältesenke (22) und dem wärmeabsorptionsseitigen Elektrodenabschnitt (43a) des ersten thermoelektrischen Elements (40a) geschaltet ist; und
>> eine zweite Wärmeableitungsplatte, die zwischen der Kältesenke (24) und dem wärmeerzeugungsseitigen Elektrodenabschnitt (44b) des zweiten thermoelektrischen Elements (40b) geschaltet ist.

**2.** Thermoelektrisches Modul nach Anspruch 1, das ferner einen Wärmeübertragungsblock (27) aufweist, der zwischen Verbindungsabschnitten des ersten thermoelektrischen Elements (40a) und des zweiten thermoelektrischen Elements (40b) angeordnet ist,

> wobei eine wärmeabsorptionsseitige Elektrode des ersten thermoelektrischen Elements (40a) an der Kältesenke (22) angebracht ist,
> eine wärmeerzeugungsseitige Elektrode des zweiten thermoelektrischen Elements (40b) an der Wärmesenke (24) angebracht ist,
> eine wärmeerzeugungsseitige Elektrode des ersten thermoelektrischen Elements (40a) an einer Oberfläche des Wärmeübertragungsblocks (27) angebracht ist, und
> eine wärmeabsorptionsseitige Elektrode des zweiten thermoelektrischen Elements (40b) an der anderen Oberfläche des Wärmeübertragungsblocks (27) angebracht ist.

3. Thermoelektrisches Modul nach Anspruch 2, das ferner Wärmeübertragungsblöcke (27) aufweist, die jeweils zwischen der Kältesenke (22) und dem Verbindungsabschnitt des ersten thermoelektrischen Elements (40a) sowie zwischen der Wärmesenke (24) und dem Verbindungsabschnitt des zweiten thermoelektrischen Elements (40b) angeordnet sind.

4. Thermoelektrisches Modul nach Anspruch 1, wobei eine beliebige Spannung aus einer hohen Spannung, einer mittleren Spannung, die niedriger ist als die hohe Spannung, und einer niedrigen Spannung, die niedriger ist als die mittlere Spannung, an das erste thermoelektrische Element (40a) und das zweite thermoelektrische Element (40b) angelegt wird, und

sich die Stärke der an das erste thermoelektrische Element (40a) angelegten Spannung und die Stärke der an das zweite thermoelektrische Element (40b) angelegten Spannung voneinander unterscheiden; und vorzugsweise wobei die an das zweite thermoelektrische Element (40b) angelegte Spannung größer ist als die an das erste thermoelektrische Element (40a) angelegte Spannung; und vorzugsweise wobei, wenn die an das zweite thermoelektrische Element (40b) angelegte Spannung die hohe Spannung ist, die an das erste thermoelektrische Element (40a) angelegte Spannung die mittlere Spannung oder die niedrige Spannung ist; oder wobei, wenn die an das zweite thermoelektrische Element (40b) angelegte Spannung die mittlere Spannung ist, die an das erste thermoelektrische Element (40a) angelegte Spannung die niedrige Spannung ist.

5. Thermoelektrisches Modul nach Anspruch 1, wobei eine Temperaturdifferenz ($\Delta$T1) zwischen der Wärmeabsorptionsfläche und der Wärmeerzeugungsfläche des ersten thermoelektrischen Elements (40a) so eingestellt ist, dass sie gleich einer Temperaturdifferenz ($\Delta$T2) zwischen der Wärmeabsorptionsfläche und der Wärmeerzeugungsfläche des zweiten thermoelektrischen Elements (40b) ist; oder wobei eine Temperaturdifferenz ($\Delta$T1) zwischen der Wärmeabsorptionsfläche und der Wärmeerzeugungsfläche des ersten thermoelektrischen Elements (40a) so eingestellt ist, dass sie größer als

eine Temperaturdifferenz ($\Delta$T2) zwischen der Wärmeabsorptionsfläche und der Wärmeerzeugungsfläche des zweiten thermoelektrischen Elements (40b) ist.

6. Thermoelektrisches Modul nach Anspruch 1, wobei die Kältesenke einen Wärmeleiter aufweist, der mit mehreren Wärmeaustauschstiften versehen ist, und die Kältesenke einen Wärmeleiter aufweist, der mit mehreren Wärmeaustauschstiften versehen ist, oder einen Verdampfer, durch den ein Niedertemperatur-Kältemittel fließt.

7. Kühlschrank, der aufweist:

ein Gehäuse mit einem Aufbewahrungsfach, das auf einer eingestellten Temperatur gehalten wird, die unter der Raumtemperatur liegt; eine Tür, die konfiguriert ist, das Aufbewahrungsfach zu öffnen und zu schließen; und ein thermoelektrisches Modul, das vorgesehen ist, um die Temperatur des Aufbewahrungsfachs auf die eingestellte Temperatur zu kühlen, nach einem der Ansprüche 1 bis 6, wobei die Kältesenke (22), die das thermoelektrische Modul bildet, zum Aufbewahrungsfach freiliegt, und die Wärmesenke (24), die das thermoelektrische Modul bildet, außerhalb des Aufbewahrungsfachs angeordnet ist.

8. Kühlschrank nach Anspruch 7, wobei das Aufbewahrungsfach ein beliebiges eines Kühlfachs, das auf einer Temperatur über der Gefriertemperatur gehalten wird, eines Gefrierfachs, das auf einer Temperatur unter der Gefriertemperatur gehalten wird, und eines Tiefkühlfachs aufweist, das auf einer Temperatur unter der Gefriertemperatur gehalten wird.

9. Kühlschrank nach Anspruch 7, wobei das Tiefkühlfach innerhalb des Gefrierfachs angeordnet ist und

die Kältesenke (22) des thermoelektrischen Moduls zum Tiefkühlfach freiliegt; und vorzugsweise der Kühlschrank ferner aufweist:

einen Kühlfach-Verdampfer (16), der vorgesehen ist, um das Kühlfach zu kühlen; einen Gefrierfach-Verdampfer (17), der parallel zum Kühlfach-Verdampfer (16) geschaltet und vorgesehen ist, das Gefrierfach zu kühlen, wobei die Kältesenke (24) einen Verdampfer aufweist, durch den ein Kältemittel strömt, und die Wärmesenke (24) in Reihe mit einem Einlass oder Auslass des Gefrierfach-Verdampfers (17) geschaltet ist.

**Revendications**

1. Module thermoélectrique (20, 20a, 20b, 20c, 20e), comprenant :

   un dissipateur de froid (22) ;
   un élément thermoélectrique (40) dont une surface d'absorption de chaleur est raccordée au dissipateur de froid (22) ;
   un dissipateur de chaleur (24) raccordé à une surface de génération de chaleur de l'élément thermoélectrique (40) pour évacuer la chaleur transférée du dissipateur de froid (22) à l'extérieur de l'élément thermoélectrique (40) ; et
   un couvercle d'étanchéité (26) prévu pour raccorder un bord du dissipateur de froid (22) et un bord du dissipateur de chaleur (24), afin d'entourer l'élément thermoélectrique (40) ; où l'élément thermoélectrique (40) comprend :
   une partie d'élément semi-conducteur comprenant un semi-conducteur de type P (41) et un semi-conducteur de type N (42) ;
   une partie d'électrode côté absorption de chaleur (43) disposée à une extrémité de la partie d'élément semi-conducteur ; et
   une partie d'électrode côté génération de chaleur (44) disposée à l'autre extrémité de la partie d'élément semi-conducteur ;
   le module thermoélectrique comprenant en outre une feuille de dissipation thermique (45, 46) raccordée à une extrémité de la partie d'élément semi-conducteur,
   où une partie d'électrode de la partie d'élément semi-conducteur est soudée sur la feuille de dissipation thermique (45, 46), l'élément thermoélectrique (40) comprenant :
   un premier élément thermoélectrique (40a) dont une surface d'absorption de chaleur est raccordée à un côté du dissipateur de froid (22) ; et
   un deuxième élément thermoélectrique (40b) dont une surface de génération de chaleur est raccordée à un côté du dissipateur de chaleur (24),

      où une surface de génération de chaleur du premier élément thermoélectrique (40a) et une surface d'absorption de chaleur du deuxième élément thermoélectrique (40b) sont raccordées l'une à l'autre pour transférer de la chaleur entre elles,
      où la feuille de dissipation thermique (45, 46) comprend :

         une première feuille de dissipation thermique raccordée entre le dissipateur de froid (22) et la partie d'électrode côté absorption de chaleur (43a) du premier élément thermoélectrique (40a) ; et
une deuxième feuille de dissipation thermique raccordée entre le dissipateur de chaleur (24) et la partie d'électrode côté génération de chaleur (44b) du deuxième élément thermoélectrique (40b).

2. Module thermoélectrique selon la revendication 1, comprenant en outre un bloc de transfert thermique (27) intercalé entre des parties de liaison du premier élément thermoélectrique (40a) et du deuxième élément thermoélectrique (40b),

   où une électrode côté absorption de chaleur du premier élément thermoélectrique (40a) est fixée au dissipateur de froid (22),
   une électrode côté génération de chaleur du deuxième élément thermoélectrique (40b) est fixée au dissipateur de chaleur (24),
   une électrode côté génération de chaleur du premier élément thermoélectrique (40a) est fixée à une surface du bloc de transfert thermique (27), et
   une électrode côté absorption de chaleur du deuxième élément thermoélectrique (40b) est fixée à l'autre surface du bloc de transfert thermique (27).

3. Module thermoélectrique selon la revendication 2, comprenant en outre des blocs de transfert thermique (27) intercalés respectivement entre le dissipateur de froid (22) et la partie de liaison du premier élément thermoélectrique (40a) et entre le dissipateur de chaleur (24) et la partie de liaison du deuxième élément thermoélectrique (40b).

4. Module thermoélectrique selon la revendication 1, où une tension quelconque entre une tension élevée, une tension moyenne inférieure à la tension élevée et une tension faible inférieure à la tension moyenne est appliquée au premier élément thermoélectrique (40a) et au deuxième élément thermoélectrique (40b), et

   où l'intensité de la tension appliquée au premier élément thermoélectrique (40a) et l'intensité de la tension appliquée au deuxième élément thermoélectrique (40b) sont différentes l'une de l'autre ;
   où, de préférence,
   la tension appliquée au deuxième élément thermoélectrique (40b) est supérieure à celle appliquée au premier élément thermoélectrique (40a) ;

et où, de préférence,

lorsque la tension appliquée au deuxième élément thermoélectrique (40b) est la tension élevée, la tension appliquée au premier élément thermoélectrique (40a) est la tension moyenne ou la tension faible ;

ou

où, lorsque la tension appliquée au deuxième élément thermoélectrique (40b) est la tension moyenne, la tension appliquée au premier élément thermoélectrique (40a) est la tension faible.

5. Module thermoélectrique selon la revendication 1, où une différence de température ($\Delta T1$) entre la surface d'absorption de chaleur et la surface de génération de chaleur du premier élément thermoélectrique (40a) est réglée de manière à être identique à une différence de température ($\Delta T2$) entre la surface d'absorption de chaleur et la surface de génération de chaleur du deuxième élément thermoélectrique (40b) ;

ou

où une différence de température ($\Delta T1$) entre la surface d'absorption de chaleur et la surface de génération de chaleur du premier élément thermoélectrique (40a) est réglée de manière à être supérieure à une différence de température ($\Delta T2$) entre la surface d'absorption de chaleur et la surface de génération de chaleur du deuxième élément thermoélectrique (40b).

6. Module thermoélectrique selon la revendication 1, où le dissipateur de froid comprend un conducteur thermique pourvu d'une pluralité de broches d'échange thermique, et le dissipateur thermique comprend un conducteur thermique pourvu d'une pluralité de broches d'échange thermique ou un évaporateur par lequel s'écoule un réfrigérant à basse température.

7. Réfrigérateur, comprenant :

une carrosserie comportant un compartiment de stockage maintenu à une température de consigne inférieure à la température ambiante ;
une porte prévue pour ouvrir et fermer le compartiment de stockage ; et
un module thermoélectrique prévu pour refroidir la température du compartiment de stockage à la température de consigne selon l'une quelconque des revendications 1 à 6, où le dissipateur de froid (22) constituant le module thermoélectrique est exposé au compartiment de stockage, et
le dissipateur de chaleur (24) constituant le module thermoélectrique est disposé à l'extérieur du compartiment de stockage.

8. Réfrigérateur selon la revendication 7, où le compartiment de stockage comprend un compartiment quelconque entre un compartiment de réfrigération maintenu à une température supérieure à la température de congélation, un compartiment de congélation maintenu à une température sous le point de congélation, et un compartiment de surgélation maintenu à une température inférieure à la température de congélation.

9. Réfrigérateur selon la revendication 7, où le compartiment de congélation est disposé à l'intérieur du compartiment de congélation, et

le dissipateur de froid (22) du module thermoélectrique est exposé au compartiment de congélation ;
et où, de préférence,
ledit réfrigérateur comprend en outre :

un évaporateur de compartiment de réfrigération (16) prévu pour refroidir le compartiment de réfrigération ;
un évaporateur de compartiment de congélation (17) relié en parallèle à l'évaporateur de compartiment de réfrigération (16) et prévu pour refroidir le compartiment de congélation,
où le dissipateur de chaleur (24) comprend un évaporateur où circule un fluide réfrigérant, et
le dissipateur de chaleur (24) est relié en série à une entrée ou à une sortie de l'évaporateur de compartiment de congélation (17).

# FIG. 1

# FIG. 2

# FIG. 3

FIG. 4

# FIG. 5

# FIG. 6

# FIG. 7

(a)

(b)

(c)

# FIG. 8

# FIG. 9

# FIG. 10

# FIG. 11

# FIG. 12

# FIG. 13

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 20180105572

- KR 101519071 B1